# EUROPEAN PATENT APPLICATION

(11) **EP 3 632 674 A1**
(43) Date of publication of application: **08.04.2020**
(21) Application number: 18809358.7
(22) Date of filing: 26.04.2018
(51) Int. Cl.: B32B 15/04, B29C 45/14, B32B 3/10, C23C 14/08, C23C 14/14, C23C 14/58

(54) **STRUCTURE, DECORATIVE FILM, METHOD FOR MANUFACTURING STRUCTURE, AND METHOD FOR MANUFACTURING DECORATIVE FILM**

(30) Priority: 30.05.2017 JP 2017106471
(71) Applicant: Sony Corporation, Tokyo 108-0075 (JP)
(72) Inventor: SHIMODA, Kazuhito, Tokyo 108-0075 (JP); ABE, Atsuhiro, Tokyo 108-0075 (JP); FUKUSHIMA, Yoshihito, Tagajyo-shi Miyagi 985-0842 (JP)
(74) Representative: D Young & Co LLP
(86) International application number: PCT/JP2018/016989
(87) International publication number: WO 2018/221099

(57) **Abstract**

A structure according to an embodiment of the present technology includes: a decorative portion; and a member.
The decorative portion includes a metal layer having a first surface, a second surface on a side opposite to the first surface, a first internal region, a second internal region, and minute cracks, the second surface having a reflectance higher than that of the first surface, the first internal region having a relatively high hardness on a side of the first surface, the second internal region having a relatively low hardness on a side of the second surface. The member includes a to-be-decorated region to which the decorative portion is to be bonded.

## Description

### Technical Field

The present technology relates to a structure applicable to an electronic apparatus, a vehicle, and the like, a decorative film, a method of producing the structure, and a method of producing the decorative film.

### Background Art

From the past, a member that is capable of causing electromagnetic waves such as millimeter waves to be transmitted therethrough while having a metallic appearance has been devised as a casing component of an electronic apparatus and the like. For example, Patent Literature 1 discloses an exterior component for mounting an automobile radar on an emblem of an automobile. For example, indium is deposited on a resin film, and this film is attached to a surface layer of the emblem by an insert molding method. Accordingly, an exterior component having an ornamental metallic luster and no absorption range in an electromagnetic frequency band due to an island structure of indium can be produced (e.g., paragraph [0006] of the specification of Patent Literature 1).

However, the method of forming the island structure of indium has a problem of difficulties in forming a film having a uniform thickness overall in the case where, for example, the deposition region is large. Further, there is also a problem that the island structure is easily broken due to a temperature of the resin to be poured in at a time of molding the casing component (e.g., paragraphs [0007] and [0008] of the specification of Patent Literature 1).

In order to solve this problem, patent literature 1 discloses the following technology. Specifically, a sea-island structure including metal regions as islands and a non-metal region surrounding the islands as a sea is artificially formed in a regular pattern. Then, the metal regions are insulated from each other by the non-metal region, and an area of the metal regions and an interval between adjacent metal regions are properly controlled. With this, a material that has electromagnetic-wave permeability comparable to a film on which indium is deposited can be obtained (e.g., paragraph [0013] of the specification of patent literature 1).

Patent Literature 2 discloses a heat-shielding film that blocks heat rays and causes visible light and electromagnetic waves to be transmitted therethrough. In this heat-shielding film, a metal stacked portion in which a metal oxide layer such as ITO and a metal layer such as Ag are stacked on a base film is formed. Then, in order to improve the visible light/electromagnetic waves transmission properties, cracks are formed in the metal stacked portion. It is described that by suppressing the reflectance of visible light to 25% or less, a product having a low metallic luster and excellent appearance is realized (paragraphs [0008], [0040] to [0051], and [0089] of the specification of Patent Literature 2, etc.).

### Citation List

### Patent Literature

Patent Literature 1: Japanese Patent Application Laid-open No. 2010-251899
Patent Literature 2: Japanese Patent Application Laid-open No. 2016-144930

### Disclosure of Invention

### Technical Problem

There is a demand for a technology for producing a member that is not only capable of causing radio waves to be transmitted therethrough while having a metallic luster but also has a high design property.

In view of the circumstances as described above, it is an object of the present technology to provide a structure that is capable of causing radio waves to be transmitted therethrough while having a metallic appearance and has a high design property, a decorative film, a method of producing the structure, and a method of producing the decorative film.

In view of the circumstances as described above, it is an object of the present invention to provide.

### Solution to Problem

In order to achieve the above-mentioned object, a structure according to an embodiment of the present technology includes: a decorative portion; and a member.

The decorative portion includes a metal layer having a first surface, a second surface on a side opposite to the first surface, a first internal region, a second internal region, and minute cracks, the second surface having a reflectance higher than that of the first surface, the first internal region having a relatively high hardness on a side of the first surface, the second internal region having a relatively low hardness on a side of the second surface.

The member includes a to-be-decorated region to which the decorative portion is to be bonded.

In this structure, the metal layer is formed so that the hardness of the first internal region on the side of the first surface having a low reflectance is relatively high and the hardness of the second internal region on the side of the second surface having a high reflectance is relatively low. As a result, for example, it is possible to form the above-mentioned metal layer with aluminum or the like having a high reflectance. As a result, it is possible to realize a structure that is capable of causing radio waves to be transmitted therethrough while having a metallic appearance and has a high design property.

The metal layer may contain a substance and a metal, the substance having a first hardness, the metal having a reflectance higher than that of the substance and a second hardness lower than the first hardness. In this case, a proportion of the substance contained in the first internal region may be higher than a proportion of the substance contained in the second internal region and a proportion of the metal contained in the second internal region may be higher than a proportion of the metal contained in the first internal region.

As a result, even in the case of using aluminum or the like as the metal, it is possible to easily form minute cracks.

The metal layer may have a first layer and a second layer, the first layer being formed of a substance having a first hardness, the second layer being formed of a metal having a reflectance higher than that of the substance and a second hardness lower than the first hardness and being stacked on the first layer.

As a result, even in the case of forming the second layer with aluminum or the like, it is possible to easily form minute cracks.

The substance having the first hardness may be a metal, metalloid, metal compound, or metalloid compound.

As a result, it is possible to easily form minute cracks.

The substance having the first hardness may be a metal.

As a result, it is possible to prevent the metallic luster from being deteriorated, and maintain the high design property.

The metal having the second hardness may be aluminum, silver, gold, or copper.

Since it is possible to use aluminum, silver, or the like having a high reflectance to realize a metal layer that is capable of causing radio waves to be transmitted therethrough, a high design property can be exhibited.

The substance having the first hardness may be chromium, silicon, titanium, cobalt, iron, or nickel.

By using the metal and metalloid, it is possible to easily form minute cracks and prevent the metallic luster from being deteriorated.

The substance having the first hardness may be aluminum oxide, iron oxide, chromium oxide, cerium oxide, zirconium oxide, titanium oxide, silicon oxide, magnesium oxide, boron nitride, titanium nitride, silicon carbide, or boron carbide.

As a result, it is possible to easily form minute cracks.

The first internal region may be a region from a predetermined position between a center in a thickness direction of the metal layer and the first surface to the first surface. In this case, the second internal region may be a region from a predetermined position between the center and the second surface to the second surface.

As a result, it is possible to easily form minute cracks and realize a structure that is capable of causing radio waves to be transmitted therethrough while having a metallic appearance and has a high design property.

The first internal region may have a relatively high Mohs hardness. In this case, the second internal region may have a relatively low Mohs hardness.

As a result, it is possible to easily form minute cracks.

The first layer may have a thickness of 10 nm or more and 300 nm or less. In this case, the second layer may have a thickness of 30 nm or more and 300 nm or less.

As a result, it is possible to exhibit a sufficient radio wave transmission property while maintaining a high reflectance.

A pitch of the minute cracks may be within a range of 1 µm or more and 500 µm or less.

As a result, it is possible to exhibit a sufficient radio wave transmission property.

The second surface may have a surface reflectance of 50% or more in a visible light region.

As a result, it is possible to exhibit a high design property due to a metallic luster.

The minute cracks may be irregularly formed.

As a result, it is possible to exhibit a high design property.

The structure may be formed as at least one of a casing component, a vehicle, or an architectural structure.

By applying the present technology, it is possible to realize a casing component, a vehicle, and an architectural structure that are capable of causing radio waves to be transmitted therethrough while having a metallic appearance and has a high design property.

A decorative film according to an embodiment of the present technology includes: a base film; and a metal layer.

The metal layer is formed on the base film and has a first surface, a second surface on a side opposite to the first surface, a first internal region, a second internal region, and minute cracks, the second surface having a reflectance higher than that of the first surface, the first internal region having a relatively high hardness on a side of the first surface, the second internal region having a relatively low hardness on a side of the second surface.

A method of producing a structure according to an embodiment of the present technology includes: forming a metal layer that has a first surface and a second surface having a reflectance higher than that of the first surface on a base film by deposition such that a hardness of a first internal region on a side of the first surface is higher than that of a second internal region on a side of the second surface.

Minute cracks are formed on the metal layer by stretching the base film.

A decorative film including the metal layer on which the minute cracks are formed is formed.

A transfer film is formed by bonding a carrier film onto the decorative film.

A molded component is formed such that the decorative film is transferred from the transfer film by an in-mold molding method, a hot stamp method, or a vacuum molding method.

In this production method, the metal layer is formed on the metal layer so that the hardness of the first internal region on the side of the first surface having a low reflectance is relatively high and the hardness of the second internal region on the side of the second surface having a high reflectance is relatively low. Then, the minute cracks are formed by stretching the base film. As a result, it is possible to use aluminum or the like having a high reflectance for the metal layer, and realize a structure that is capable of causing radio waves to be transmitted therethrough while having a metallic appearance and has a high design property.

In the method of producing a structure according to another embodiment of the present technology, a transfer film including the metal layer on which the minute cracks are formed is formed. Further, a molded component is formed such that the metal layer peeled off from the base film is transferred by an in-mold molding method, a hot stamp method, or a vacuum molding method.

In the method of producing a structure according to another embodiment of the present technology, a molded component is formed integrally with the decorative film by an insert molding method.

The method of producing a decorative film according to an embodiment of the present technology includes: forming a metal layer that has a first surface and a second surface having a reflectance higher than that of the first surface on a base film by deposition such that a hardness of a first internal region on a side of the first surface is higher than that of a second internal region on a side of the second surface.

Minute cracks are formed on the metal layer by stretching the base film.

### Advantageous Effects of Invention

As described above, in accordance with the present technology, it is possible to realize a structure that is capable of causing radio waves to be transmitted therethrough while having a metallic appearance and has a high design property. It should be noted that the effects described herein are not necessarily limited, and any effect described in the present disclosure may be obtained.

### Brief Description of Drawings

[Fig. 1] Fig. 1 is a schematic diagram showing a configuration example of a mobile terminal as an electronic apparatus according to an embodiment.
[Fig. 2] Fig. 2 is a schematic cross-sectional view showing a configuration example of a metal decorative portion shown in Fig. 1.
[Fig. 3] Fig. 3 is a schematic cross-sectional view showing a configuration example of a metal layer.
[Fig. 4] Fig. 4 is a photograph taken by enlarging the surface state of the metal layer of a glossy film with a microscope.
[Fig. 5] Fig. 5 is a photograph showing the surface state in the case where the thickness of a high hardness layer formed of chromium differs.
[Fig. 6] Fig. 6 is a schematic diagram showing a configuration example of a vacuum deposition apparatus
[Fig. 7] Fig. 7 is a schematic diagram showing a configuration example of a biaxial stretching apparatus.
[Fig. 8] Fig. 8 is a schematic diagram showing a configuration example of a vacuum deposition apparatus for forming another metal layer.
[Fig. 9] Fig. 9 is a schematic diagram describing a metal layer formed by the vacuum deposition apparatus shown in Fig. 8.
[Fig. 10] Fig. 10 is a schematic diagram describing another configuration example of the metal layer.
[Fig. 11] Fig. 11 is a photograph showing the surface state of a metal layer in which a highly-reflective layer (100 nm) formed of aluminum and a high hardness layer (50 nm) formed of cobalt are stacked.
[Fig. 12] Fig. 12 is a diagram describing another method of forming the metal layer.
[Fig. 13] Fig. 13 is a schematic diagram showing a configuration example of the metal layer formed by the method shown in Fig. 12.
[Fig. 14] Fig. 14 is a photograph showing the surface state of a metal layer formed as an aluminum layer to which oxygen has been added.
[Fig. 15] Fig. 15 is a schematic cross-sectional view showing another configuration example of the metal decorative portion.
[Fig. 16] Fig. 16 is a schematic cross-sectional view showing a configuration example of the metal layer shown in Fig. 15.
[Fig. 17] Fig. 17 is a table showing the reflectance of a highly-reflective surface before and after a high-temperature high-humidity test performed on the glossy film.
[Fig. 18] Fig. 18 is a schematic diagram describing an in-mold molding method.
[Fig. 19] Fig. 19 is a schematic diagram describing an insert molding method.
[Fig. 20] Fig. 20 is a schematic diagram showing a configuration example of a transfer film including a base film and the metal layer.
[Fig. 21] Fig. 21 is a cross-sectional view showing a configuration example of a glossy film according to another embodiment.
[Fig. 22] Fig. 22 is a diagram showing a relationship between a thickness of a coating layer formed as a support layer and a pitch of minute cracks. Mode(s) for Carrying Out the Invention

Hereinafter, embodiments of the present technology will be described with reference to the drawings.

### [Configuration of Electronic Apparatus]

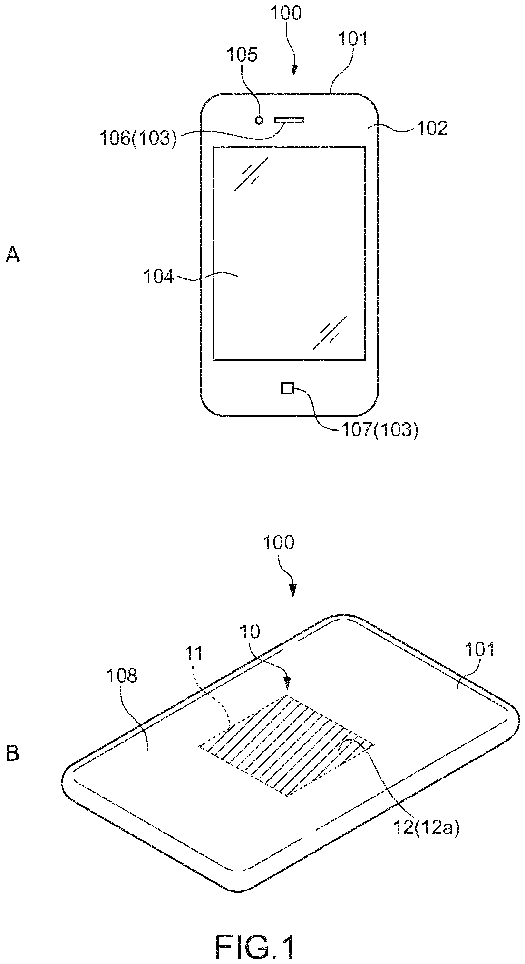

Fig. 1 is a schematic diagram showing a configuration example of a mobile terminal as an electronic apparatus according to an embodiment of the present technology. Part A of Fig. 1 is a front view showing a front side of a mobile terminal 100, and Part B of Fig. 1 is a perspective view showing a back surface side of the mobile terminal 100.

The mobile terminal 100 includes a casing portion 101 and electronic components (not shown) accommodated in the casing portion 101. As shown in Part A of Fig. 1, in a front surface portion 102 that is a front surface side of the casing portion 101, a phone call portion 103, a touch panel 104, and a face-to-face camera 105 are provided. The phone call portion 103 is provided for talking with a telephone partner and includes a speaker portion 106 and an audio input portion 107. A voice of the telephone partner is output from the speaker portion 106, and a voice of a user is transmitted to the partner side via the audio input portion 107.

Various images and GUIs (Graphical User Interfaces) are displayed on the touch panel 104. The user is capable of viewing a still image or a moving image via the touch panel 104. Further, the user inputs various touch operations via the touch panel 104. The face-to-face camera 105 is used for imaging a face of the user and the like. Specific configurations of the respective devices are not limited.

As shown in Part B of Fig. 1, a metal decorative portion 10 decorated so as to exhibit a metallic appearance is provided on a back surface portion 108 that is a back surface side of the casing portion 101. The metal decorative portion 10 is capable of causing radio waves to be transmitted therethrough while having a metallic appearance.

Although descriptions will be given later in detail, a to-be-decorated region 11 is formed in a predetermined region of the back surface portion 108. A decorative film 12 is bonded to the to-be-decorated region 11, thereby forming the metal decorative portion 10. Therefore, the to-be-decorated region 11 corresponds to a region where the metal decorative portion 10 is to be formed.

In this embodiment, the decorative film 12 corresponds to a decorative portion. Further, the casing portion 101 on which the to-be-decorated region 11 is formed corresponds to a member. By the casing portion 101 including the to-be-decorated region 11 and the decorative film 12 bonded to the to-be-decorated region 11, a structure according to the present technology is formed as a casing component. Note that the structure according to the present technology may be used as a part of the casing component.

In the example shown in Part B of Fig. 1, the metal decorative portion 10 is partially formed at substantially the center of the back surface portion 108. A position at which the metal decorative portion 10 is formed is not limited and may be set as appropriate. For example, the metal decorative portion 10 may be formed on the entire back surface portion 108. As a result, it is possible to make the entire back surface portion 108 uniformly metallic in appearance.

By making other portions around the metal decorative portion 10 appear substantially the same as the metal decorative portion 10, it is also possible to make the entire back surface portion 108 uniformly metallic in appearance. In addition, it is also possible to improve a design property by forming portions other than the metal decorative portion 10 to have other appearances such as woody texture. The position and size of the metal decorative portion 10, the appearance of other portions, and the like only need to be set as appropriate so that a design property that the user desires is exhibited.

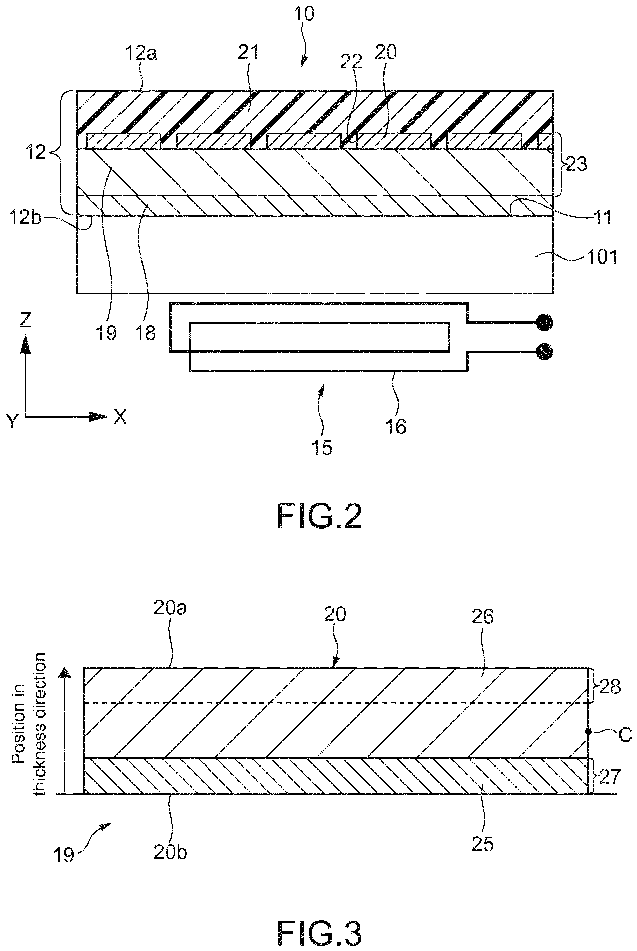

The decorative film 12 to be bonded to the to-be-decorated region 11 has a design surface 12a. The design surface 12a is a surface that can be visually recognized by a user who uses the mobile terminal 100, and is a surface that is one of elements constituting the appearance (design) of the casing portion 101. In this embodiment, the surface directed to the front surface side of the back surface portion 108 is the design surface 12a of the decorative film 12. That is, the surface opposite to a bonding surface 12b (see Fig. 2) to be bonded to the to-be-decorated region 11 is the design surface 12a.

In this embodiment, as the electronic component to be accommodated in the casing portion 101, an antenna portion 15 (see Fig. 2) capable of communicating with an external reader/writer or the like via radio waves is accommodated. The antenna portion 15 includes, for example, a base substrate (not shown), an antenna coil 16 (see Fig. 2) formed on the base substrate, a signal processing circuit portion (not shown) to be electrically connected to the antenna coil 16, and the like. A specific configuration of the antenna portion 15 is not limited. Note that various electronic components such as an IC chip and a capacitor may be accommodated as the electronic components to be accommodated in the casing portion 101.

Fig. 2 is a schematic cross-sectional view showing a configuration example of the metal decorative portion 10. As described above, the metal decorative portion 10 includes the to-be-decorated region 11 formed in a region corresponding to the position of the antenna portion 15 and the like, and the decorative film 12 to be bonded to the to-be-decorated region 11.

The decorative film 12 includes an adhesive layer 18, a base film 19, a metal layer 20, and a sealing resin 21. The adhesive layer 18 is a layer for bonding the decorative film 12 to the to-be-decorated region 11. The adhesive layer 18 is formed by applying an adhesive material onto a surface of the base film 19 on the other side of the surface on which the metal layer 20 is formed. A type of the adhesive material, a coating method, and the like are not limited. The surface of the adhesive layer 18 to be bonded to the to-be-decorated region 11 is the bonding surface 12b of the decorative film 12.

The base film 19 is formed of a stretchable material, and a resin film is typically used. As the material of the base film 19, for example, PET (polyethylene terephthalate), PC (polycarbonate), PMMA (polymethyl methacrylate), PP (polypropylene), or the like is used. Other materials may also be used.

Note that since the base film 19 is a layer in contact with metal, for example, if a vinyl chloride material is used, the liberated chlorine may promote corrosion of the metal. Therefore, by selecting a non-vinyl chloride material as the base film 19, it is possible to prevent the metal from being corroded. It goes without saying that the present technology is not limited thereto.

The metal layer 20 is formed to make the to-be-decorated region 11 have a metallic appearance. The metal layer 20 is a layer to be formed on the base film 19 by vacuum deposition, and a large number of minute cracks (hereinafter, referred to as minute cracks) 22 are formed.

By these minute cracks 22, a plurality of discontinuous surfaces is formed in the metal layer 20, and a surface resistance value becomes an almost-insulated state. Therefore, it is possible to sufficiently suppress an occurrence of eddy currents when radio waves hit the casing portion 101. As a result, a reduction of electromagnetic wave energy due to an eddy current loss can be sufficiently suppressed, and a high radio wave transmission property is realized.

A film thickness of the metal layer 20 is set within a range of, for example, 30 nm or more and 300 nm or less. If the film thickness is too small, a reflectance of a visible light region is lowered because light is transmitted. If the film thickness is too large, the reflectance is lowered because a surface shape is apt to be roughened. Further, the smaller the film thickness, the larger the reflectance reduction amount after a high-temperature high-humidity test (e.g., after 75°C 90% RH 48 H). Note that RH represents relative humidity.

By setting the film thickness within the range described above in consideration of these points, it has been possible to realize a radio wave transmission surface in which a high reflectance is maintained. By setting the film thickness within the range of 30 nm or more and 150 nm or less in particular, a high reflectance has been sufficiently maintained, and a high radio wave transmission property has been exhibited. It goes without saying that the present technology is not limited to these ranges, and the film thickness of the metal layer 20 may be set as appropriate so that desired characteristics are exhibited. Further, an optimum numerical value range may be set again within the range of 30 nm or more and 300 nm or less, for example.

The sealing resin 21 is formed of a transparent material and functions as a protective layer (hard coat layer) that protects the base film 19 and the metal layer 20. The sealing resin 21 is formed by applying, for example, a UV curable resin, a thermosetting resin, or a two-component curable resin. By forming the sealing resin 21, for example, smoothing, antifouling, peeling prevention, scratch prevention, and the like are realized. Note that as the protective layer, an acrylic resin or the like may be coated. Selecting a non-vinyl chloride material as the sealing resin 21 is advantageous for preventing metal from being corroded.

Further, the sealing resin 21 has also a function of fixing the minute cracks 22 in the metal layer 20 to suppress re-bonding. That is, the sealing resin 21 functions also as a fixing layer. As a result, it is possible to exert a sufficient radio wave transmission property and maintain the radio wave transmission property for a long time. Note that a layer that functions as the protective layer and a layer that functions as the fixing layer may be formed separately from each other, and may be formed on the metal layer 20 as a cover layer having a two-layer structure.

The front surface of the sealing resin 21, i.e., the surface opposite to the surface on the side covering the metal layer 20 is the design surface 12a of the decorative film 12. Note that a printing layer or the like may be formed on the front surface (the design surface 12a) of the sealing resin 21 or on the lower surface of the sealing resin 21. As a result, it is possible to improve the design property.

In this embodiment, in the case of forming the decorative film 12, a glossy film 23 including the base film 19 and the metal layer 20 is formed first. After that, the adhesive layer 18 and the sealing resin 21 are formed on the glossy film 23. Note that the order in which the respective layers are formed is not limited to this. In addition, the adhesive layer 18 and the sealing resin 21 may be omitted depending on molding conditions of the casing portion 101, and the like. In this case, the glossy film 23 is bonded to the to-be-decorated region 11 as the decorative film according to the present technology.

Fig. 3 is a schematic cross-sectional view showing a configuration example of the metal layer 20. In Fig. 3, illustration of the minute cracks 22 is omitted.

The metal layer 20 includes a high hardness layer 25 formed on the base film 19, and a highly-reflective layer 26 to be stacked on the high hardness layer 25. A surface (hereinafter, referred to as a highly-reflective surface) 20a of the metal layer 20 on the side of the highly-reflective layer 26 is a surface on the side of the design surface 12a of the decorative film 12 shown in Fig. 2, and is a surface to be visually recognized by a user via the transparent sealing resin 21. A surface (hereinafter, referred to as a high hardness surface) 20b of the metal layer 20 on the side of the high hardness layer 25 is connected to the base film 19.

In this embodiment, a chromium layer formed of chromium having a Mohs hardness of approximately nine is formed as the high hardness layer 25. Further, an aluminum layer formed of aluminum having a Mohs hardness of approximately 2.5 and a reflectance higher than that of chromium is formed as the highly-reflective layer 26. The thickness of the high hardness layer 25 is approximately 50 nm, and the thickness of the highly-reflective layer 26 is approximately 100 nm.

By forming the metal layer 20 in which the highly-reflective layer 26 formed of metal having a high reflectance and the high hardness layer 25 having a hardness higher than that of the highly-reflective layer 26 are stacked as described above, it is possible to easily form the minute cracks 22 by stretching the base film 19. This is presumably because the high hardness layer 25 becomes a region where the tensile strength at break is low in the film and the minute cracks 22 are formed starting from the region. That is, it is considered that following the break of the high hardness layer 25, also the highly-reflective layer 26 is broken, and the minute cracks 22 are formed in the entire the metal layer 20.

As a result, it is possible to use, for example, aluminum, which has a low hardness and is difficult to generate cracks by stretching, to form the metal layer 20. That is, it is possible to form the highly-reflective layer 26 on the side of the design surface 12a with aluminum or the like. Since aluminum has a high reflectance in the visible light region, it is possible to exert a high reflectance in the design surface 12a (highly-reflective surface 20a). As a result, it is possible to realize a metallic luster having a high design property.

The highly-reflective layer 26 functions as a layer for realizing a metallic luster having a high design property mainly in the design surface 12a (highly-reflective surface 20a). The high hardness layer 25 functions as a layer for inducing the occurrence of cracks mainly in the highly-reflective layer 26.

In this embodiment, the high hardness surface 20b on the side of the high hardness layer 25 corresponds to a first surface. The highly-reflective surface 20a on the side of the highly-reflective layer 26 corresponds to a second surface having a reflectance higher than that of the first surface. Further, the high hardness layer 25 corresponds to a first internal region 27 having a relatively high hardness on the side of the first surface. Further, a region in the vicinity of the highly-reflective surface 20a on the side of the highly-reflective layer 26 corresponds to a second internal region 28 having a relatively low hardness on the side of the second surface. Typically, the first and second internal regions 27 and 28 are defined by substantially the same thicknesses. It goes without saying that the present technology is not limited thereto.

To which position (distance) from the surface in the thickness direction of the metal layer 20 a region is defined as the internal region on the side of the surface is not limited. Typically, it is possible to define, as the first internal region 27, a region from a predetermined position between a center C in the thickness direction of the metal layer 20 and the high hardness surface 20b to the high hardness surface 20b. Further, it is possible to define, as the second internal region 28, a region from a predetermined position between the center C and the highly-reflective surface 20a to the highly-reflective surface 20a. It goes without saying that the present technology is not limited thereto.

In the example shown in Fig 3, it is possible to define, as the first internal region 27, a region thinner or thicker than the high hardness layer 25, and define, as the second internal region 28, a region having the substantially the same thickness as that, the thickness being a thickness from the highly-reflective surface 20a. Even in the case where regions thinner than the high hardness layer 25 are defined as the first and second internal regions 27 and 28, the first internal region 27 becomes a region having a relatively high hardness and the second internal region 28 becomes a region having a relatively low hardness.

In the case where regions thicker than the high hardness layer 25 are defined as the first and second internal regions 27 and 28, the first internal region 27 contains chromium and aluminum. Also in this case, paying attention to the average hardness of each of the first and second internal regions 27 and 28, i.e., the average of the hardness of chromium and the hardness of aluminum contained in each of the internal regions, the first internal region 27 becomes a region having a relatively high hardness and the second internal region 28 becomes a region having a relatively low hardness.

That is, in the present disclosure, the hardness of the internal region includes the average hardness that is the average of the hardness of each of one or more substances contained in the internal region. Note that although the hardness of the internal region is defined by a Mohs hardness in this embodiment, the present technology is not limited thereto. Also in the case where other scales such as Vickers hardness, Brinell hardness, and Rockwell hardness are used, the present technology is applicable.

In this embodiment, chromium forming the high hardness layer 25 corresponds to a substance having a first hardness. Further, aluminum forming the highly-reflective layer 26 corresponds to metal having a reflectance higher than that of the substance having the first hardness, and a second hardness lower than the first hardness.

In the metal layer 20, the proportion of chromium contained in the first internal region 27 is higher than the proportion of chromium contained in the second internal region 28. Further, the proportion of aluminum contained in the second internal region 28 is higher than the proportion of aluminum contained in the first internal region 27. This is a feature that is observed even in the case where the thickness of each of the first and second internal regions 27 and 28 is thinner or thicker than that of the high hardness layer 25 (hereinafter, referred to as a feature A).

For example, in the case where regions corresponding to the thickness of the high hardness layer 25 from the high hardness surface 20b and the highly-reflective surface 20a, or regions thinner than those are defines as the first and second internal regions 27 and 28, respectively, the proportion of chromium contained in the first internal region 27 is substantially 100% and the proportion of aluminum is substantially 0%. On the other hand, the proportion of chromium contained in the second internal region 28 is substantially 0%, and the proportion of aluminum is substantially 100%. Therefore, the feature A described above is recognized.

In the case where regions thicker than the high hardness layer 25 are defined as the first and second internal regions 27 and 28, the proportion of chromium contained in the first internal region 27 is smaller than 100%, and the proportion of aluminum is larger than 0%. However, the proportion of chromium contained in the second internal region 28 is substantially 0%, and the proportion of aluminum is substantially 100%. Therefore, the feature A described above is observed.

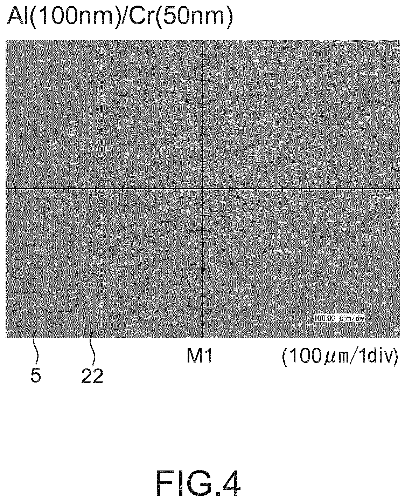

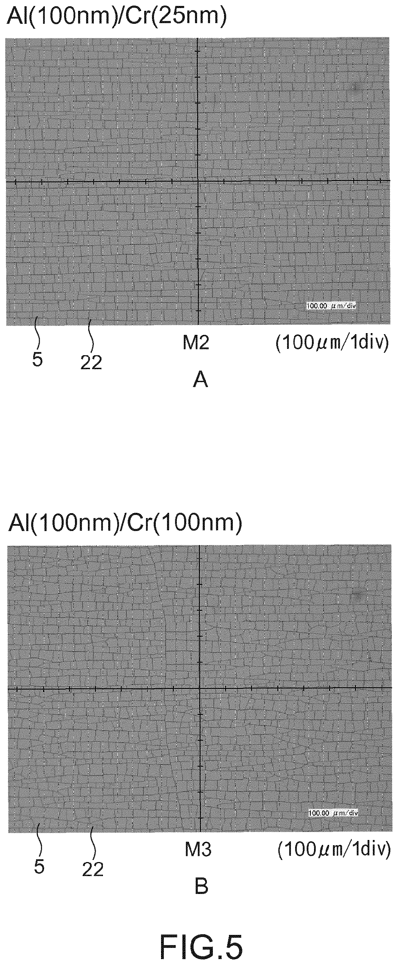

Fig. 4 is a photograph taken by enlarging the surface state of the metal layer 20 of the glossy film 23 with a microscope. This photograph M1 has been taken including a scale, but the line on the photograph is reinforced and shown in order to make it easy to recognize the scale. Further, regarding the photograph M1, there is a preparation for submitting a color photograph. These points apply to other photographs (M2 to M5) such as Fig. 5.

In this embodiment, the metal layer 20 in which the high hardness layer 25 formed of chromium and the highly-reflective layer 26 formed of aluminum are stacked is formed on the base film 19. Then, by biaxially stretching the base film 19 under the conditions of a stretching rate (stretching amount with respect to the original size) of 2% and a substrate heating temperature of 130°C, the minute cracks 22 is formed.

As shown in the photograph M1, the minute cracks 22 are irregularly formed in the metal layer 20. "Irregularly formed" means that the formation mode of the minute cracks 22 has no regularity, and it can be also said that the minute cracks 22 are randomly formed.

For example, as shown in Fig. 4, there is no regularity in the direction of the minute cracks 22 and numerable cracks 22 are formed in random directions. Alternatively, it can be said that there is no regularity in the shape of each of regions 5 surrounded by the minute cracks 22 and numerable regions 5 having random shapes are formed by the minute cracks 22.

The pitch (crack interval) of the minute cracks 22 is set within the range of, for example, 1 µm or more and 500 µm or less. That is, the minute cracks 22 are formed so that the size of each of the regions 5 segmented by the minute cracks 22 is substantially included in the range of 1 µm or more and 500 µm or less. In the example shown in Fig. 4, the pitch of the cracks 22 is approximately 10 to 50 µm.

For example, if the pitch is too small, light reflected on the surface of the metal layer 20 is scattered or the area of the gap having a light transmission property is relatively increased, which reduces the reflectance. Meanwhile, if the pitch is too large, the radio wave transmission property is reduced. By setting the pitch within the range of 1 µm or more and 500 µm or less, it is possible to realize a radio wave transmission property while maintaining a high reflectance. For example, it is possible to sufficiently transmit electromagnetic waves (wavelength of approximately 12.2 cm) at 2.45 GHz of WiFi or Bluetooth (registered trademark).

It goes without saying that the present technology is not limited to this range, and the pitch of the minute cracks 22 may be set as appropriate so that desires characteristics are exhibited. For example, by setting the pitch within the range of 50 µm or more and 200 µm or less, a high reflectance and a high radio wave transmission property have been sufficiently exhibited. In addition, for example, an optimum numerical value range may be set again within the range of 1 µm or more and 500 µm or less, for example.

When the sheet resistance of the metal layer 20 of the photograph M1 was evaluated with a four-probe resistor, insulation was shown. Further, when the surface reflectance (average reflectance) of the visible light region (400 nm to 700 nm) was measured using a spectrophotometer (U-4100 "manufactured by Hitachi, Ltd. "), the obtained value was 70% or more. That is, it has become possible to realize the metal layer 20 whose surface has a metallic luster and a high reflectance, which has a sufficient radio wave transmission property.

Note that in the case where a protective layer such as a sealing resin and a hard coat layer is formed, the surface reflectance is reduced by approximately 5%. Even in consideration of this, by using the decorative film 12 according to the present technology, it is possible to achieve a high value of the surface reflectance, i.e., 65% or more, while the protective layer is formed.

Fig. 5 is a photograph showing the surface state in the case where the thickness of the high hardness layer 25 formed of chromium differs. In the metal layer 20 shown in Part A of Fig 5, the high hardness layer 25 having a thickness of approximately 25 nm is formed. In this case, the minute cracks 22 are formed in a mesh shape along the biaxial direction in which the base film 19 is stretched. That is, regularity is found in the formation mode of the minute cracks 22 and the direction of the minute cracks 22 is substantially equal to one of the biaxial directions. This can be said that the shape of each of the regions 5 surrounded by the minute cracks 22 is substantially rectangular. The pitch of the minute cracks 22 is approximately 50 µm.

In the metal layer 20 shown in Part B of Fig. 5, the high hardness layer 25 having a thickness of approximately 100 nm is formed. In this case, the cracks 22 that occur along the biaxial direction and the irregularly formed cracks 22 are mixed. The pitch of the minute cracks 22 is approximately 50 µm.

As shown in the photographs M1 to M3, by controlling the thickness of the high hardness layer 25, it is possible to make the formation mode of the minute cracks 22 differ. That is, it is possible to select the mode in which the minute cracks 22 are irregularly formed as shown in the photograph M1, the mode in which the minute cracks 22 are regularly formed as shown in the photograph M2, and the mode in which both the states are mixed as shown in the photograph M3, as appropriate. This is presumably because there is a possibility that the hardness of a thin film-like substance changes depending on the thickness.

Note that by comparing the case where the minute cracks 22 are irregularly formed and the case where the minute cracks 22 are regularly formed, it has been found that the visibility (degree of conspicuity) of the minute cracks 22 can be more reduced in the case where the minute cracks 22 are irregularly formed. This is presumably because the minute cracks 22 stand out in the case where the directions of the minute cracks 22 are aligned.

Therefore, by controlling the thickness of the high hardness layer 25, it is possible to control the visibility of the minute cracks 22. For example, by controlling the thickness of the high hardness layer 25 so that the minute cracks 22 are irregularly formed, it is possible to improve the design property of the design surface 12a (highly-reflective surface 20a). Note that it is also possible to control the pitch of the cracks 22 by controlling the thickness of the high hardness layer 25. For example, it is also possible to reduce the visibility by reducing the pitch of the cracks 22.

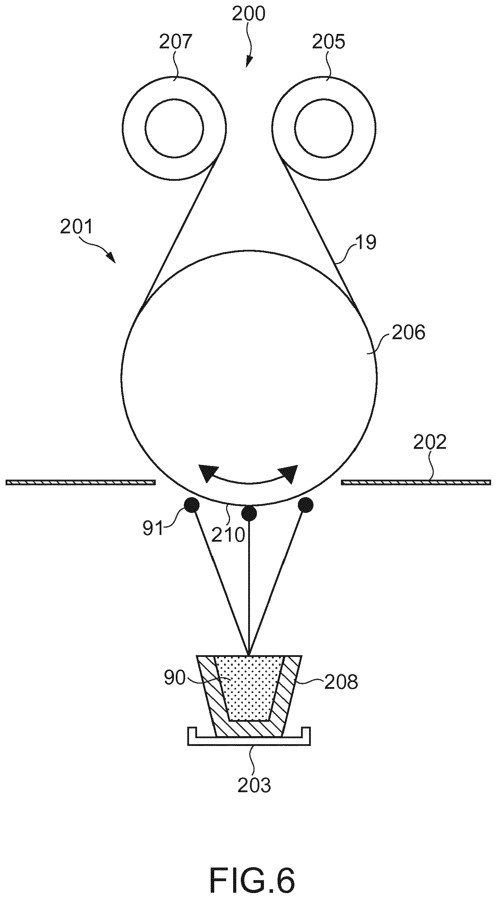

Fig. 6 is a schematic diagram showing a configuration example of a vacuum deposition apparatus. A vacuum deposition apparatus 200 includes a film conveyor mechanism 201 disposed inside a vacuum chamber (not shown), a partition wall 202, a mounting table 203, and a heating source (not shown).

The film conveyor mechanism 201 includes a first roll 205, a rotary drum 206, and a second roll 207. When the rotary drum 206 rotates to the right, the base film 19 is conveyed from the first roll 205 toward the second roll 207 along a circumferential surface of the rotary drum 206. When the rotary drum 206 rotates to the left, the base film 19 is conveyed from the second roll 207 toward the first roll 205.

The mounting table 203 is disposed at a position facing the rotary drum 206. On the mounting table 203, a crucible 208 in which a material forming the metal layer 20 to be formed in the base film 19 is accommodated is disposed. A region of the rotary drum 206 facing the crucible 208 is a deposition region 210. The partition wall 202 restricts fine particles 91 of a deposition material 90, which proceed at angles directed toward regions other than the deposition region 210.

In this embodiment, the crucible 208 in which chromium forming the high hardness layer 25 is accommodated is placed on the mounting table 203 first. The base film 19 is conveyed while the rotary drum 206 is sufficiently cooled. For example, the rotary drum 206 rotates to the right and the base film 19 is conveyed from the first roll 205 toward the second roll 207.

In accordance with the convey of the base film 19, chromium in the crucible 203 is heated by a heating source (not shown) such as a heater, a laser, and an electron gun. As a result, vapor containing the fine particles 91 is generated from the crucible 203. The fine particles 91 of chromium contained in the vapor are deposited on the base film 19 that travels through the deposition region 210, whereby the high hardness layer 25 formed of chromium is formed on the base film 19. By controlling the feed speed of the base film 19, the evaporation rate of the molten metal, or the like, it is possible to control the thickness of the layer to be deposited.

Next, the crucible 208 in which aluminum that is a metal forming the highly-reflective layer 26 is accommodated is placed on the mounting table 203. The rotary drum 206 rotates to the left and the base film 19 in which the high hardness layer 25 is formed is conveyed from the second roll 207 toward the first roll 205. By heating aluminum in the crucible 208 in accordance with the convey, the highly-reflective layer 26 is deposited on the high hardness layer 25. In this embodiment, the deposition start surface is the high hardness surface 20b, and the deposition end surface is the highly-reflective surface 20a.

Since continuous vacuum deposition by a roll-to-roll method is possible in this embodiment, a significant cost reduction and improvement of productivity can be achieved. It goes without saying that the present technology is also applicable to a case where a batch-type vacuum deposition apparatus is used.

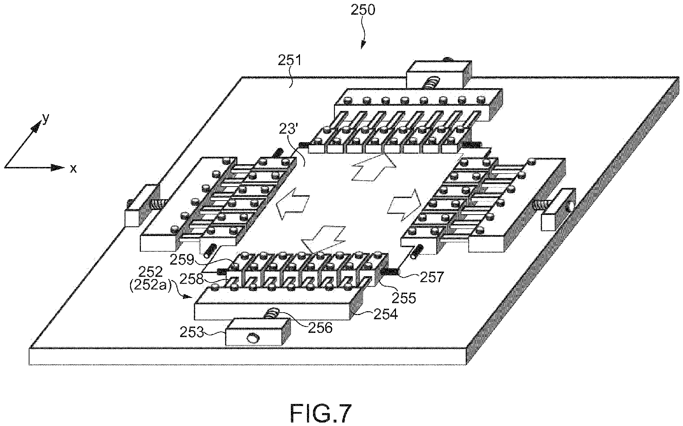

Fig. 7 is a schematic diagram showing a configuration example of a biaxial stretching apparatus. A biaxial stretching apparatus 250 includes a base member 251 and four stretching mechanisms 252 that are to be arranged on the base member 251 and have substantially the same configuration. The four stretching mechanisms 252 are arranged two each on the two axes orthogonal to each other (x axis and y axis) while opposing to each other on the respective axes. Hereinafter, descriptions will be given while referring to a stretching mechanism 252a that stretches a glossy film 23' in a direction opposite to that of the arrow in the y-axis direction.

The stretching mechanism 252a includes a fixed block 253, a movable block 254, and a plurality of clips 255. The fixed block 253 is fixed to the base member 251. A stretching screw 256 extending in a stretching direction (y direction) penetrates the fixed block 253.

The movable block 254 is movably disposed on the base member 251. The movable block 254 is connected to the stretching screw 256 penetrating the fixed block 253. As a result, by operating the stretching screw 256, the movable block 254 becomes moveable in the y direction.

The plurality of clips 255 is arranged along a direction (x direction) orthogonal to the stretching direction. A slide shaft 257 extending in the x direction penetrates each of the plurality of clips 255. A position of each of the clips 255 in the x direction can be changed along the slide shaft 257. Each of the plurality of clips 255 and the movable block 254 are coupled by coupling links 258 and coupling pins 259.

The stretching rate is controlled by an operation amount of the stretching screw 256. Further, the stretching rate can also be controlled by appropriately setting the number and positions of the plurality of clips 255, the length of the coupling links 258, and the like. Note that the configuration of the biaxial stretching apparatus 250 is not limited. The biaxial stretching apparatus 250 according to this embodiment biaxially stretches a film with a full cut sheet, but is also capable of biaxially stretching it continuously with a roll. For example, continuous biaxial stretching becomes possible by applying a tension in a traveling direction between the rolls and a tension that forms a right angle to the traveling direction by the clips 255 moving in synchronization with the traveling, which are provided between the rolls.

The glossy film 23' obtained after the vacuum deposition is placed on the base member 251, and the plurality of clips 255 of the stretching mechanisms 252 are attached to the 4 sides. While the glossy film 23' is heated by a temperature-controlled heating lamp (not shown) or temperature-controlled hot air, the four stretching screws 256 are operated to perform biaxial stretching. In this embodiment, the base film 19 is biaxially stretched under the conditions of a stretching rate of 2% in the respective axial directions and a substrate heating temperature of 130°C. As a result, as shown in Fig. 4, the minute cracks 22 are irregularly formed. Alternatively, as shown in Fig. 5, the minute cracks 22 in a mesh shape are formed along directions (biaxial directions) orthogonal to the stretching direction.

If the stretching rate is too low, appropriate minute cracks 22 are not formed, and thus the metal layer 20 have conductivity. In this case, due to an influence of eddy currents or the like, a sufficient radio wave transmission property is not exhibited. Meanwhile, if the stretching rate is too large, damage to the base film 19 after stretching becomes large. As a result, in the case of bonding the decorative film 12 to the to-be-decorated region 11, there is a possibility that a yield is deteriorated due to entrainment of air, wrinkling, and the like. Further, due to the deformation of the base film 19 or the metal layer 20 itself, the design property of the metal decorative portion 10 is lowered in some cases. This problem may also occur in the case where the metal layer 20 is peeled off from the base film 19 and transferred.

In the glossy film 23 according to this embodiment, the minute cracks 22 can be appropriately formed with a low stretching rate of 2% or less in the respective axial directions. As a result, the base film 19 can be sufficiently prevented from being damaged, and the yield can be improved. Further, the design property of the metal decorative portion 10 to which the decorative film 12 is bonded can be maintained high. It goes without saying that the stretching rate can be set as appropriate, and the stretching rate of 2% or more may be set as long as the defects described above do not occur.

### [Other Configuration Examples of Metal Layer]

As the metal layer 20 including the high hardness surface 20b, the highly-reflective surface 20a on the side opposite thereto, the first internal region 27 having a relatively high hardness on the side of the high hardness surface 20b, and the second internal region 28 having a relatively low hardness on the side of the highly-reflective surface 20a, various other configuration examples are given.

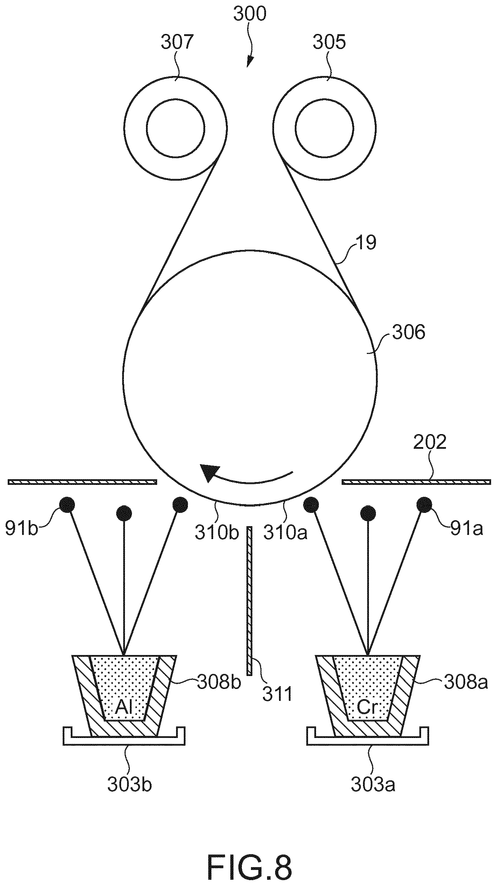

Fig. 8 is a schematic diagram showing a configuration example of a vacuum deposition apparatus for forming another metal layer. This vacuum deposition apparatus 300 includes a first mounting table 303a, a second mounting table 303b, and an intermediate partition wall 311. The first mounting table 303a is disposed offset from the front of a rotary drum 306 toward the side on which a first roll 305 is disposed. The second mounting table 303b is disposed offset from the front of the rotary drum 306 toward the side on which a second roll 307 is disposed.

The intermediate partition wall 311 is disposed between the first and second mounting tables 303a and 303b, and located in front of the rotary drum 306. The intermediate partition wall 311 divides the deposition region into a first deposition region 310a on the side of the first mounting table 303a and a second deposition region 310b on the side of the second mounting table 303b.

A crucible 308a in which chromium is accommodated is placed on the first mounting table 303a. A crucible 308b in which aluminum is accommodated is placed on the second mounting table 303b. The rotary drum 306 rotates to the right and the base film 19 is conveyed from the first roll 305 toward the second roll 307. In accordance therewith, chromium in the crucible 308a and aluminum in the crucible 308b are heated.

The side on which the crucible 308a in which chromium has been accommodated is placed is the upstream side, and the first deposition region 310a becomes a deposition region of the high hardness layer 25. Fine particles 91a of chromium are deposited on the base film 19 that travels through the first deposition region 310a, whereby the high hardness layer 25 is formed.

The side on which the crucible 308b in which aluminum has been accommodated is the downstream side, and the second deposition region 310b is a deposition region of the highly-reflective layer 26. Fine particles 91b of aluminum are deposited on the high hardness layer 25 on the base film 19 that travels through the second deposition region 310b, whereby the highly-reflective layer 26 is formed.

By dividing the deposition region as described above, it is possible to form the high hardness layer 25 and the highly-reflective layer 26 in the same process without reciprocating the base film 19. As a result, it is possible to further significantly reduce a cost and improve productivity.

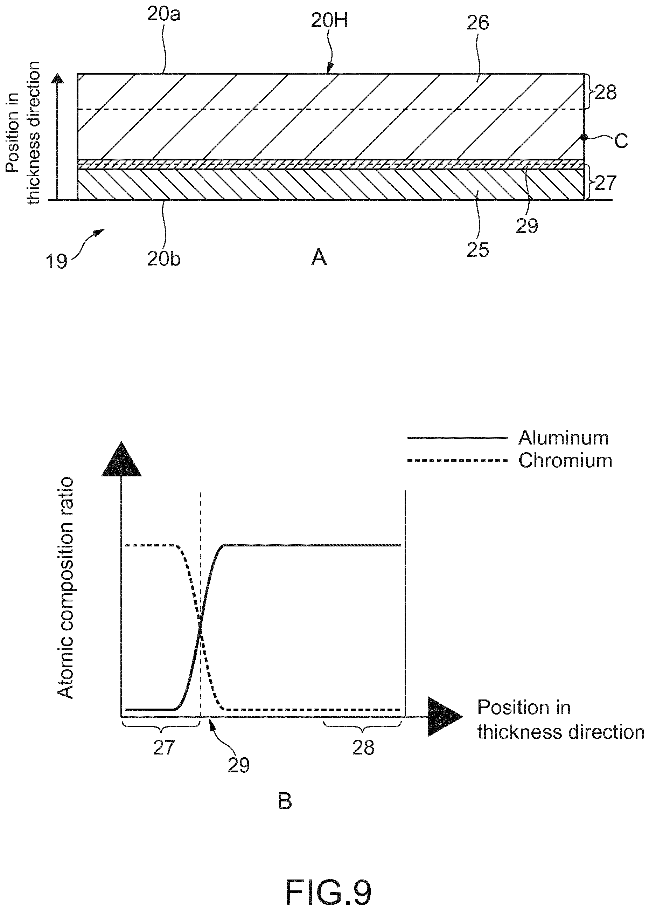

Part A of Fig. 9 is a schematic cross-sectional view showing a configuration example of a metal layer 20H formed by the vacuum deposition apparatus 300 shown in Fig. 8. Part B of Fig. 9 is a schematic graph showing the atomic composition ratio of between chromium and aluminum at positions in the thickness direction of the metal layer 20H.

For example, the fine particles 91a of chromium travel to the second deposition region 310b in some cases without being restricted by the intermediate partition wall 311 shown in Fig. 8. Similarly, the fine particles 91b of aluminum travel to the deposition region 319a in some cases.

Therefore, as shown in Parts A and B of Fig. 9, there is a possibility that a mixed region 29 in which chromium and aluminum are mixed is formed at the boundary between the high hardness layer 25 and the highly-reflective layer 26. Also such a configuration in which the mixed region 29 is formed is included in the configuration of the metal layer according to the present technology.

That is, also the metal layer 20H shown in Fig. 9 is a metal layer including the first internal region 27 having a relatively high hardness and the second internal region 28 having a relatively high hardness, and the various effects described above are exhibited. Further, also the feature A relating to the proportion of chromium and the proportion of aluminum in the first and second internal regions 27 and 28 is also observed.

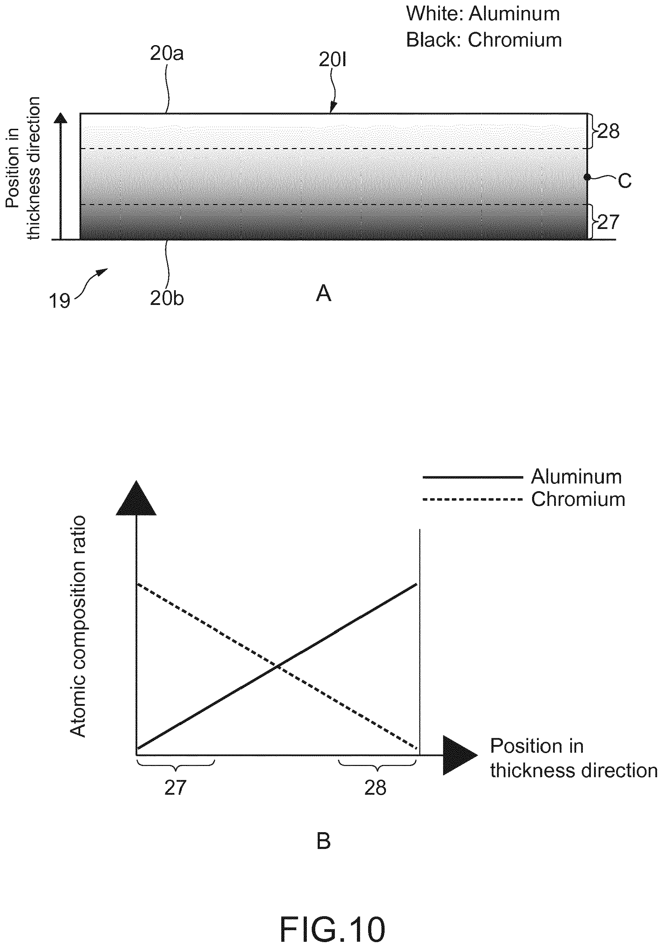

Further, as shown in Parts A and B of Fig. 10, the proportion of each of chromium and aluminum may be controlled in the thickness direction of a metal layer 201 to form a metal layer. For example, the metal layer 201 is configured so that the proportion of chromium decreases and the proportion of aluminum increases from the high hardness surface 20b to the highly-reflective surface 20a.

Also such a configuration in which the high hardness layer and the highly-reflective layer are difficult to distinguish is included in the configuration of a metal layer according to the present technology, and the various effects are exhibited. That is, the metal layer 201 including the first internal region 27 having a relatively high hardness and the second internal region 28 having a relatively low hardness is obtained, and the feature A relating to the proportion of chromium and aluminum is observed.

The material forming the metal layer is not limited to chromium and aluminum. Various combinations of a substance having the first hardness and a metal having the second hardness lower than the first hardness and a reflectance higher than that of the substance having the first hardness may be employed. Hereinafter, the substance having the first hardness will be referred to as a high hardness substance, and the metal having the second hardness will be referred to as a highly-reflective metal.

For example, as the highly-reflective metal, a metal having a high reflectance in the visible light region, such as aluminum and silver (Ag), is used. Further, as the highly-reflective metal, a metal such as gold (Au) and copper (Cu) may be used. Then, as the high hardness substance, a metal, metalloid, metal compound, or metalloid compound having a relatively high hardness is used.

The Mohs hardness of aluminum, silver, gold, and copper is approximately 2.5. Therefore, as the high hardness substance, a metal, metalloid, metal compound, or metalloid compound having a Mohs hardness higher than approximately 2.5 can be used. For example, the following substances can be used. It goes without saying that the present technology is not limited to these materials.

Chromium (Cr): Mohs hardness of approximately 9
Silicon (Si): Mohs hardness of approximately 7
Titanium (Ti): Mohs hardness of approximately 6
Cobalt (Co): Mohs hardness of approximately 5.5
Iron (Fe): Mohs hardness of approximately 4.5
Nickel (Ni): Mohs hardness of approximately 3.5
Aluminum oxide (Al₂O₃): Mohs hardness of approximately 9
Iron oxide (Fe₂O₃): Mohs hardness of approximately 6
Chromium oxide (Cr₂O₃): Mohs hardness of approximately 6
Cerium oxide (CeO₂): Mohs hardness of approximately 6
Zirconium oxide (ZrO₂): Mohs hardness of approximately 6
Titanium oxide (TiO₂): Mohs hardness of approximately 5.5
Silicon oxide (SiO₂): Mohs hardness of approximately 7
Magnesium oxide (MgO): Mohs hardness of approximately 6.5
Boron nitride (BN): Mohs hardness of approximately 9
Titanium nitride (TiN): Mohs hardness of approximately 9
Silicon carbide (SiC): Mohs hardness of approximately 9.5
Boron carbide (B₄C): Mohs hardness of approximately 9

Note that a metal to be used as the highly-reflective metal in some configurations may be used as the high hardness substance in other configurations.

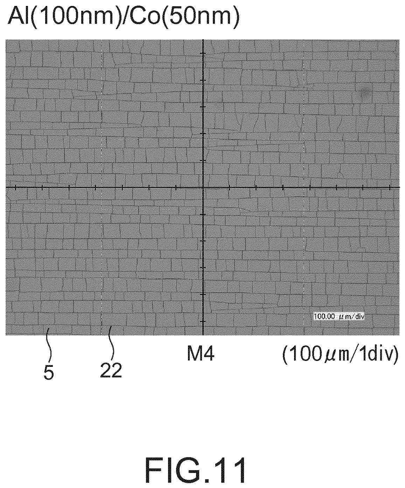

Fig. 11 is a photograph showing the surface state of a metal layer in which a highly-reflective layer (100 nm) formed of aluminum and a high hardness layer (50 nm) formed of cobalt are stacked. As shown in a photogram M4, the minute cracks 22 have been formed in a mesh shape along the biaxial direction in which the base film 19 is stretched. As a result, the metal layer 20 whose surface has a metallic luster and a high reflectance, which has a sufficient radio wave transmission property, has been realized. Note that the pitch of the cracks 22 is approximately 50 to 100 um, and the pitch is larger as compared with the case where the high hardness layer (50 nm) formed of chromium is formed. By appropriately selecting the high hardness substance as described above, it is possible to appropriately control the presence/absence of the regularity of the cracks 22 and the pitch of the cracks 22.

If the difference in hardness between the high hardness substance and the highly-reflective metal is small, it is difficult to form the minute cracks 22 by stretching in some cases. For example, the high hardness layer 25 formed of copper (Cu) has been formed for the highly-reflective layer 26 formed of aluminum. Then, the base film 19 has been stretched under the same conditions as those in the case where the high hardness layer 25 formed of chromium or cobalt is formed.

Under the condition that the minute cracks 22 are appropriately formed in the case where the high hardness layer 25 formed of chromium or cobalt is formed, the minute cracks 22 are not formed in the case where the high hardness layer 25 formed of copper is formed in some cases. This is presumably because cracks do not occur in copper and no force that induces cracks is generated. It goes without saying that by controlling the stretching condition or the like, it is possible to form the minute cracks 22 even in the high hardness layer 25 formed of copper.

Note that also in the case of stretching the single metal layer formed of aluminum or single metal layer formed of chromium under the same stretching condition, the minute cracks 22 have been hardly formed and the obtained metal layer 20 has had conductivity on the surface. By adding the high hardness substance, it is possible to easily form the minute cracks 22. Further, by selecting a material of the high hardness substance and controlling the thickness of the high hardness layer 25, it is possible to control the crack pitch and the crack shape.

The present inventors have used various high hardness substances to form the high hardness layer 25 within the range of 10 nm or more and 300 nm or less, and have used various highly-reflective metals to form the highly-reflective layer 26 within the range of 30 nm or more and 300 nm or less. As a result, it has been possible to form the decorative film 12 that exhibits a high reflectance and a high radio wave transmission property. For example, it has been possible to easily produce the decorative film 12 having the surface reflectance of 50% or more in the visible light region of the highly-reflective surface 20a. Further, it has also been possible to easily produce the decorative film 12 having the surface reflectance of 70% or more in the visible light region.

Further, it has been possible to form the decorative film 12 having a very high reflectance and radio wave transmission property by forming the high hardness layer 25 and the highly-reflective layer 26 so that the condition that the entire film thickness of the metal layer 20 described above is within the range of 30 nm or more and 300 nm or less is satisfied. Note that by thinning the high hardness layer 25, it is possible to improve the productivity.

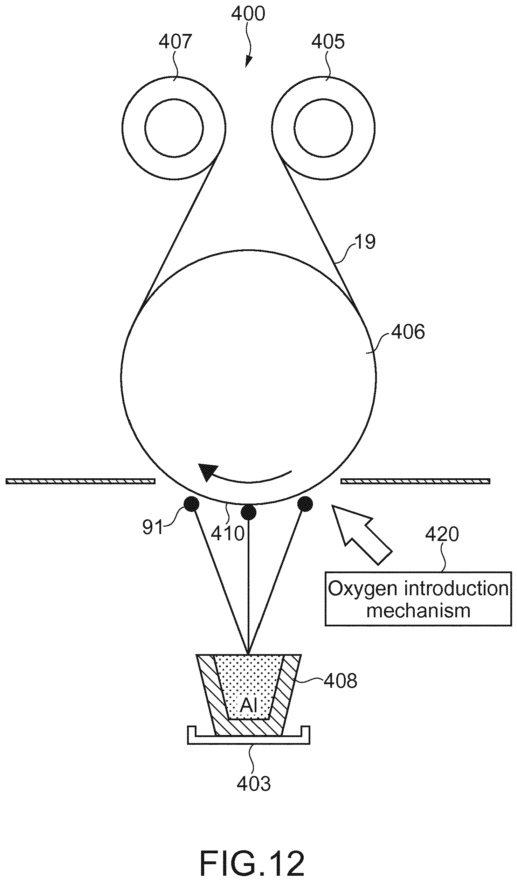

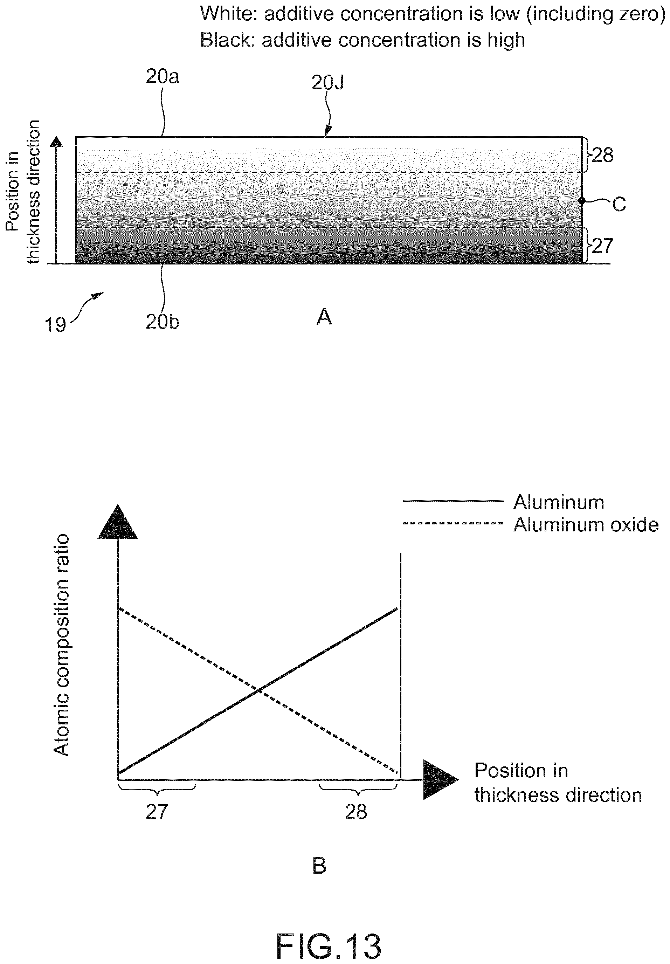

Fig. 12 is a diagram describing another method of forming the metal layer. Fig. 13 is a schematic diagram showing a configuration example of the metal layer formed by the method shown in Fig. 12. Here, as the high hardness substance and the highly-reflective metal, a case where a metal layer 20J containing aluminum oxide and aluminum is formed will be described as an example.

As shown in Fig. 12, a crucible 408 in which aluminum is accommodated is placed on a mounting table 403 of a vacuum deposition apparatus 400. Further, on the upstream side (on the side of a first roll 405) of a deposition region 410, an oxygen introduction mechanism 420 is disposed. The introduction amount (flow rate: seem) of oxygen to be introduced by the oxygen introduction mechanism 420 is not limited and may be set as appropriate.

A rotary drum 406 rotates to the right and the base film 19 is conveyed from the first roll 405 toward a second roll 407. In accordance with the convey of the base film 19, the oxygen introduction mechanism 420 spray oxygen toward the base film 19. Aluminum in the crucible 408 is heated and the fine particles 91 of aluminum are deposited on the base film 19 that travels through the deposition region 410. As a result, an aluminum layer to which oxygen has been added is deposited as the metal layer 20J.

Since the oxygen introduction mechanism 420 is disposed on the upstream side, the amount of oxygen added to the metal layer 20J formed on the base film 19 on the upstream side of the deposition region 410 is larger as shown in Fig. 13. Meanwhile, the amount of oxygen added to the metal layer 20J formed on the downstream side is smaller. That is, the deposition start surface is a surface having the highest additive concentration and the deposition end surface is a surface having the lowest additive concentration.

Therefore, it is possible to easily form the metal layer 20J in which the proportion of the aluminum oxide that is the high hardness substance decreases and the proportion of aluminum that is the highly-reflective metal increases from the deposition start surface (high hardness surface 20b) to the deposition end surface(highly-reflective surface 20a).

This metal layer 20J is a metal layer including the first internal region 27 having a relatively high hardness and the second internal region 28 having a relatively low hardness, the various effects described above are exhibited. Further, the feature A relating to the proportion of aluminum oxide and aluminum in the first and second internal regions 27 and 28 is observed.

In the case where a compound of the highly-reflective metal is used as the high hardness substance for inducing the cracks 22 as described above, the highly-reflective metal may be caused to react with a predetermined element at the time of deposition of the metal layer to form a compound of the metal. As a result, it is possible to reduce a cost and improve productivity.

It goes without saying that the element to be supplied is not limited to oxygen, and it is possible to easily generate a metal layer containing a nitride compound or the like by supplying nitrogen (N) or the like.

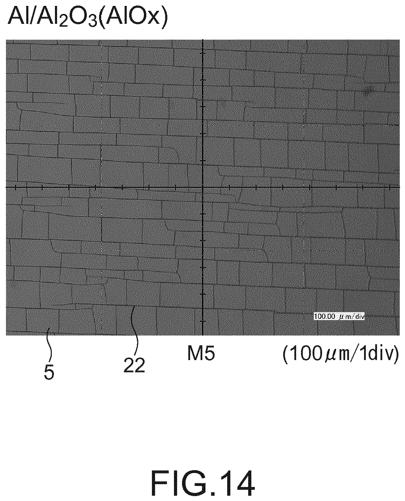

Fig. 14 is a photograph showing the surface state of the metal layer 20J formed as an aluminum layer to which oxygen has been added (it can be said that this metal layer 20J is an AlOx thin film as a whole). As shown in the photograph M5, the minute cracks 22 have been formed in a mesh shape along the biaxial direction in which the base film 19 is stretched. As a result, the metal layer 20 whose surface has a metallic luster and a high reflectance, which has a sufficient radio wave transmission property, has been realized. Note that the pitch of the cracks 22 is approximately 100 to 200 um, which is slightly large.

Note that the analysis of the composition inside the metal layer 20 can be performed by a known technology such as analysis using a cross-sectional TEM (Transmission Electron Microscope), analysis using SEM/EDX (scanning electron microscope/energy dispersive X-ray spectroscopy), and analysis of narrow scan spectrum (angular resolution measurement) for A12p using X-ray photoelectron spectroscopy (XPS).

Therefore, whether or not it is the metal layer 20 including the high hardness surface 20b, the highly-reflective surface 20a on the side opposite thereto, the first internal region 27 having a relatively high hardness on the side of the high hardness surface 20b, and the second internal region 28 having a relatively low hardness on the side of the highly-reflective surface 20a can be sufficiently determined.

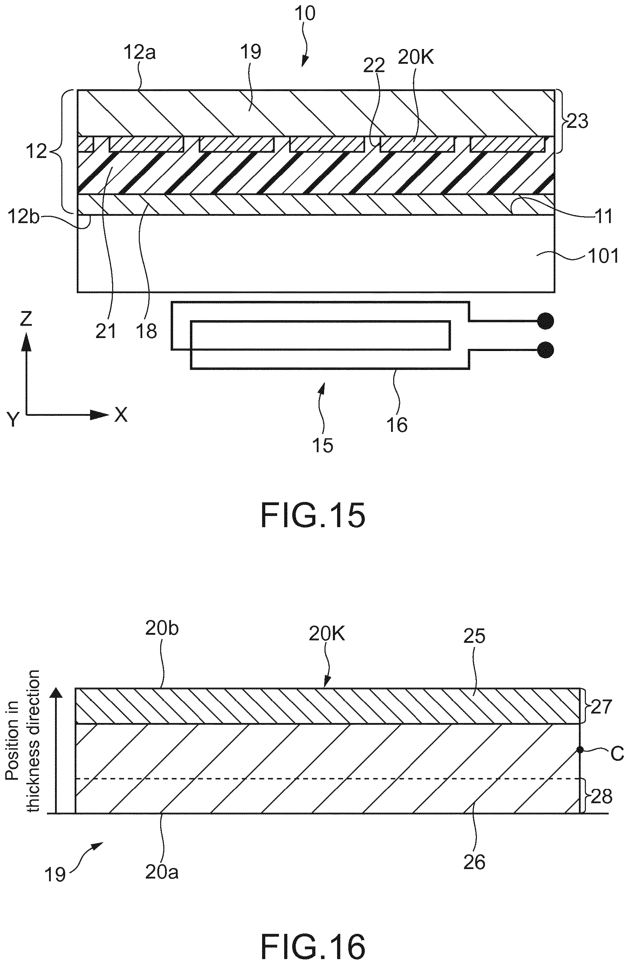

Fig. 15 is a schematic cross-sectional view showing another configuration example of the metal decorative portion. In the example shown in Fig. 15, the adhesive layer 18 is formed on the sealing resin 21 covering a metal layer 20K and the sealing resin 21 side is bonded to the to-be-decorated region 11 of the casing portion 101. Therefore, a surface of the base film 19 opposite to the surface on which the metal layer 20K is formed is the design surface 12a of the decorative film 12. In this case, a transparent base film 19 is used and the sealing resin 21 may be transparent. That is, an arbitrarily colored one may be used as the sealing resin 21. As a result, it is possible to improve the design property.

Note that a protective layer may be formed on the base film 19 or the base film 19 may have a function as a protective layer. Further, a layer having all functions of a protective layer that protects the metal layer 20K, a fixed layer that suppresses rebonding of the minute cracks 22, and a bonding layer for bonding the decorative film 12 to the to-be-decorated region 11 may be formed so as to cover the metal layer 20.

Fig. 16 is a schematic cross-sectional view showing a configuration example of the metal layer 20K shown in Fig. 15. In the configuration shown in Fig. 15, the contact surface of the metal layer 20K in contact with the base film 19 is a surface on the side of the design surface 12a. Therefore, the metal layer 20K is formed so that the surface in contact with the base film 19 is the highly-reflective surface 20a, and the surface opposite thereto is the high hardness surface 20b. Further, the metal layer 20K is formed so that the first internal region 27 having a relatively high hardness is formed on the side of the high hardness surface 20b and the second internal region 28 having a relatively low hardness is formed on the side of the highly-reflective surface 20a.

Therefore, the metal layer only needs to be formed so that the highly-reflective surface 20a and the high hardness surface 20b are reversed with respect to the base film 19. For example, as in the metal layer 20K shown in Fig. 16, the highly-reflective layer 26 is formed on the base film 19, and the high hardness layer 25 is stacked thereon. It goes without saying that also the metal layer that does not have a clear two-layer structure only needs to be formed so that the highly-reflective surface 20a and the high hardness surface 20b are reversed with respect to the base film 19.

For example, in the case of reciprocating the base film 19 by switching the rotation direction of the rotary drum 206 as described with reference to Fig. 6, it only needs to reverse the order of placing the crucible 208. That is, first, the crucible 208 in which a metal forming the highly-reflective layer 26 is accommodated is placed to deposit the highly-reflective layer 26. After that, it only needs to place the crucible 208 in which a substance forming the high hardness layer 25 is accommodated to deposit the high hardness layer 25.

In the case of dividing the deposition region to deposit a metal layer in one process as described with reference to Fig. 8, it only needs to reverse the position at which the crucible is placed. That is, the crucible in which a metal forming the highly-reflective layer 26 is accommodated is placed on the mounting table 303a on the upstream side of the deposition region. It only needs to place the crucible in which a substance forming the high hardness layer 25 is accommodated on the mounting table 303b on the downstream side of the deposition region.

In the case of adding a predetermined element at the time of deposition as described with reference to Fig. 12, it only needs to reverse the position of the supply mechanism that supplies the element. That is, by disposing the supply mechanism on the downstream side, it is possible to form a metal layer in which the deposition start surface is a surface having the lowest additive concentration and the deposition end surface is a surface having the highest additive concentration.

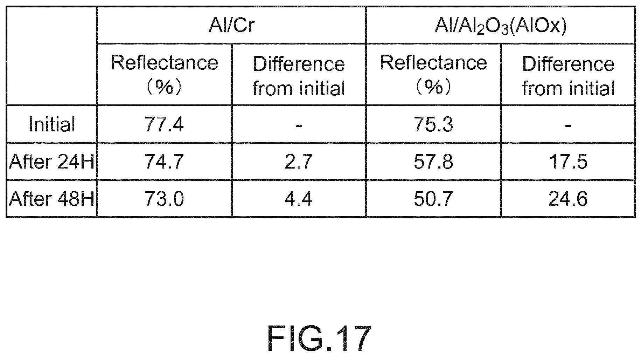

Fig. 17 is a table showing the reflectance of the highly-reflective surface 20a before and after a high-temperature high-humidity test performed on the glossy film 23. As samples, a metal layer (referred to as a sample 1) having a two-layer structure of aluminum and chromium, and a metal layer (referred to as a sample 2) that is an aluminum layer to which oxygen has been added were prepared. Note that the samples 1 and 2 were prepared so that the base film 19 side is the highly-reflective surface 20a (configuration shown in Fig. 15).

For the samples 1 and 2, the reflectance of the metal layer at the time of deposition (initial) and the surface reflectance of the visible light region (400 nm to 700 nm) after 24 H/48 H in the environment of 75°C 90% RH were measured. Note that the reflectance is a result obtained by measurement from the base film 19 side.

In the sample 1, a very high reflectance of 77.4% was obtained at the time of deposition. Note that the reflectance before the stretching process was 83.2% and it was possible to cause minute cracks to occur while maintaining the high reflectance. Further, the reflectance after 24 H was 74.7%, and the reflectance after 48 H was 73.0%. That is, the reduction amount after 24 H was 2.7, the reduction amount after 48 H was 4.4, deterioration of the metallic luster was hardly observed, and the high reflectance was maintained.

In the sample 2, a very high reflectance of 75.3% was obtained at the time of deposition. The reflectance after 24 H was 57.8%, and the reflectance after 48 H was 50.7%. That is, the reduction amount after 24 H was 17.5, the reduction amount after 48 H was 24.6, and deterioration of the metallic luster was observed.

In the sample 2, the tendency that the film minuteness was lost by addition of oxygen and the film density was reduced was observed. It is considered that a path through which moisture and the like enter from the outside is created accordingly, oxidation of the metal layer 20 is promoted, and the metallic luster is deteriorated.

By using a metal such as chromium as the high hardness substance as in the sample 1, it is possible to prevent the film density from being reduced. That is, by forming both the highly-reflective layer and the high hardness layer of metal materials, it is possible to produce the decorative film 12 having very high durability and maintain the high design property. Note that also by using a metalloid material, similar effects can be achieved.

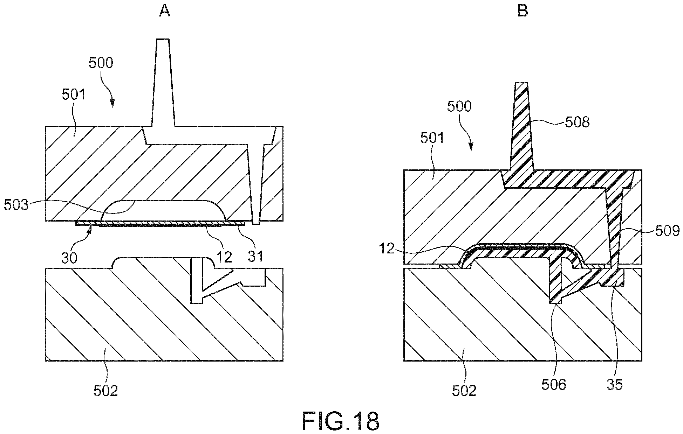

Fig. 18 is a schematic diagram describing the in-mold molding method. The in-mold molding is performed by a molding apparatus 500 including a cavity mold 501 and a core mold 502 as shown in Fig. 18. As shown in Part A of Fig. 18, a concave portion 503 corresponding to the shape of the casing portion 101 is formed in the cavity mold 501. A transfer film 30 is disposed so as to cover this concave portion 503. The transfer film 30 is formed by bonding the decorative film 12 shown in Fig. 2 to a carrier film 31. The transfer film 30 is supplied from outside the molding apparatus 500 by, for example, a roll-to-roll method.

As shown in Part B of Fig. 18, the cavity mold 501 and the core mold 502 are clamped, and a molding resin 35 is injected into the concave portion 503 via a gate portion 506 formed in the core mold 502. In the cavity mold 501, a sprue portion 508 to which the molding resin 35 is supplied and a runner portion 509 coupled thereto are formed. When the cavity mold 501 and the core mold 502 are clamped, the runner portion 509 and the gate portion 506 are coupled to each other. As a result, the molding resin 35 supplied to the sprue portion 508 is injected into the concave portion 503. Note that the configuration for injecting the molding resin 35 is not limited.

As the molding resin 35, a general-purpose resin such as an ABS (acrylonitrile butadiene styrene) resin, engineering plastics such as a PC resin and a mixed resin of ABS and PC, or the like is used. The present technology is not limited to this, and the material and color (transparency) of the molding resin may be selected as appropriate so that a desired casing portion (casing component) is obtained.

The molding resin 35 is injected into the concave portion 503 while being melted at a high temperature. The molding resin 35 is injected so as to press an inner surface of the concave portion 503. At this time, the transfer film 30 disposed in the concave portion 503 is pressed by the molding resin 35 to be deformed. The adhesive layer 18 formed on the transfer film 30 is melted by the heat of the molding resin 35, and the decorative film 12 is bonded to the surface of the molding resin 35.

After the molding resin 35 is injected, the cavity mold 501 and the core mold 502 are cooled, and the clamp is released. The molding resin 35 onto which the decorative film 12 is transferred is adhered to the core mold 502. By taking out the molding resin 35, the casing portion 101 in which the metal decorative portion 10 is formed in a predetermined region is produced. Note that the carrier film 31 is peeled off when the clamp is released.

By using the in-mold molding method, positioning of the decorative film 12 becomes easy, and the metal decorative portion 10 can be formed with ease. Further, a degree of freedom in designing the shape of the casing portion 101 is high, and thus it is possible to produce casing portions 101 of various shapes.

Note that the antenna portion 15 accommodated inside the casing portion 101 may be attached by the in-mold molding method at the time of molding the casing portion 101. Alternatively, the antenna portion 15 may be attached to the inner side of the casing portion 101 after the casing portion 101 is molded. Further, the antenna portion 15 is built in the casing in some cases.

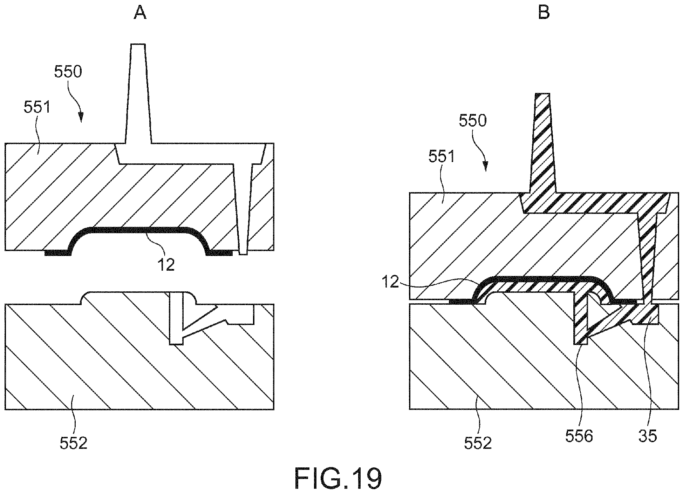

Fig. 19 is a schematic diagram describing the insert molding method. In the insert molding, the decorative film 12 is disposed as an insert film in a cavity mold 551 of a molding apparatus 550. Then, as shown in Part B of Fig. 19, the cavity mold 551 and a core mold 552 are clamped, and the molding resin 35 is injected into the cavity mold 551 via a gate portion 556. As a result, the casing portion 101 is formed integrally with the decorative film 12. It is also possible to easily form the metal decorative portion 10 by using the insert molding method. Further, the casing portions 101 of various shapes can be produced. Note that the configuration of the molding apparatus that executes the in-mold molding and the insert molding is not limited.

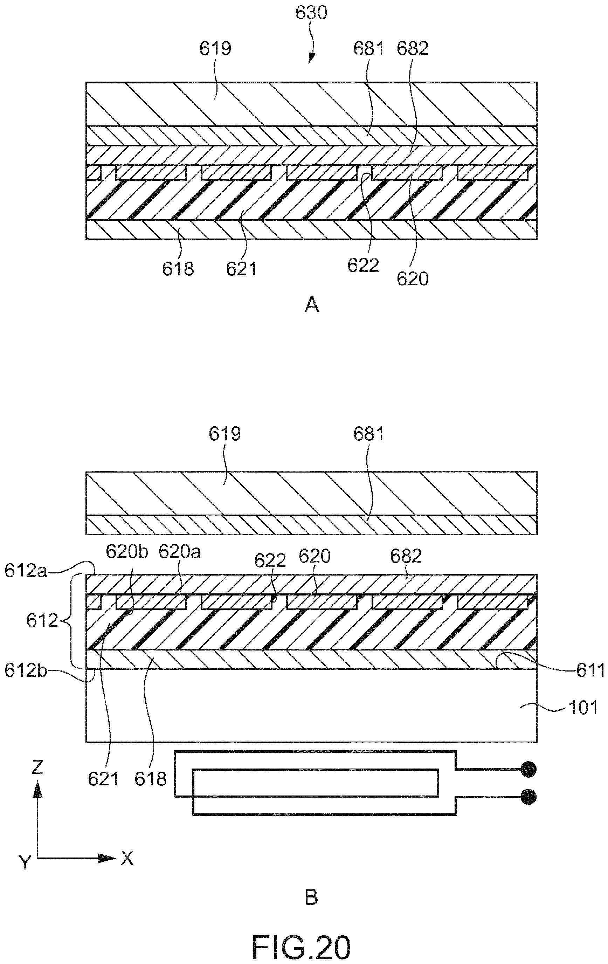

Fig. 20 is a schematic diagram showing a configuration example of a transfer film including a base film and a metal layer. This transfer film 630 includes a base film 619, a release layer 681, a hard coat layer 682, a metal layer 620, a sealing resin 621, and an adhesive layer 618. The release layer 681 and the hard coat layer 682 are formed on the base film 619 in this order.

Therefore, the metal layer 620 is formed on the base film 619 on which the release layer 681 and the hard coat layer 682 are formed. Then, the base film 619 is stretched to form minute cracks 622 in the metal layer 620.

As shown in Part B of Fig. 20, when the casing portion 101 is formed by the in-mold molding method, the base film 619 and the release layer 681 are peeled off, and a decorative film 612 including the metal layer 620 is bonded to a to-be-decorated region 611. In this way, the base film 619 may be used as a carrier film. Note that the base film 619 on which the release layer 681 is formed can also be regarded as the base film according to the present technology. Further, the decorative film 612 peeled off from the base film 619 can also be regarded as the decorative film.

Note that in the example shown in Fig. 20, the deposition start surface of the metal layer 620 is a highly-reflective surface 420a on the side of a design surface 612a, and the deposition end surface is a high hardness surface 420b on the side opposite thereto. Instead of this configuration, a transfer film may be prepared so that the deposition start surface is a high hardness surface, and the deposition end surface is a highly-reflective surface.

The casing portion 101 in which the decorative film (decorative portion) 12 including the metal layer 20 is transferred onto the to-be-decorated region 11 may be formed by a hot stamp method using the transfer films 30 and 630 shown in Fig. 18 and Fig. 20. In addition, the decorative film 12 may be bonded to the casing portion 101 by an arbitrary method such as pasting. Further, vacuum molding, pressure molding, or the like may also be used.

As described above, in the casing portion 101 (casing component) as the structure according to this embodiment, the metal layer 20 is formed so that the hardness of the first internal region 27 on the side of the high hardness surface 20b having a low reflectance is relatively high and the hardness of the second internal region 28 on the side of the highly-reflective surface 20a having a high reflectance is relatively low. Accordingly, it becomes possible to form the metal layer 20 described above with aluminum or the like having a high reflectance, for example. As a result, it is possible to realize the casing portion 101 that is capable of causing radio waves to be transmitted therethrough while having a metallic appearance and has a high design property.

in the case where a thin film having an island structure of In or Sn is used as the metal film that causes radio waves to be transmitted therethrough, the reflectance is approximately 50% to 60%. This is due to an optical constant of the material, and it is extremely difficult to realize the reflectance of 70% or more unlike the glossy film 23 according to this embodiment. In addition, since In is rare metal, material costs become high.

Further, also in a case of generating cracks in a metal film formed of nickel, copper, or the like by performing after-baking using non-electrolytic plating, it is difficult to realize the reflectance of 70% or more. Further, while it is also possible to alloy a silicon and metal to increase surface resistivity to achieve a radio wave transmission property, also in this case, it is difficult to realize the reflectance of 70% or more.

In addition, in this embodiment, since the film of the metal material is formed by vacuum deposition, a material such as Al and Ti that is difficult to be deposited on the resin can be used in wet plating such as non-electrolytic plating. Therefore, a selection range of usable metal materials is extremely wide, and a metal material having a high reflectance can be used. Further, since the minute cracks 22 are formed by biaxial stretching, it becomes possible to form the metal layer 20 with high adhesion in the vacuum deposition. As a result, the metal layer 20 does not fall during the in-mold molding or insert molding, and the casing portion 101 can be molded appropriately. In addition, durability of the metal decorative portion 10 itself can also be improved.

Further, in this embodiment, the glossy film 23 can be realized with only a two-layer film of metal. Therefore, since it becomes possible to use a simple deposition process by a simple configuration of a deposition source, apparatus costs and the like can be reduced. Note that the method of forming the metal layer to which oxygen or nitrogen has been added is not limited to the case where gas is blown toward the film conveyor mechanism 201. For example, oxygen or the like may be contained in the metal material in the crucible.

The present technology is applicable to almost all electronic apparatuses that incorporate built-in antennas or the like therein. Various examples of such an electronic apparatus include electronic apparatuses such as a cellular phone, a smartphone, a personal computer, a game machine, a digital camera, an audio apparatus, a TV, a projector, a car navigation system, a GPS terminal, and a wearable information apparatus (glasses type or wristband type), operation apparatuses such as a remote controller, a mouse, and a touch pen that operate these apparatuses by wireless communication or the like, electronic apparatuses mounted on vehicles, such as an in-vehicle radar and an in-vehicle antenna, and the like. Further, the present technology is also applicable to an IoT apparatus connected to the Internet or the like.

Further, the present technology is not limited to the casing component of an electronic apparatus and the like, and is also applicable to vehicles and architectural structures. Specifically, a structure including a decorative portion according to the present technology and a member including a to-be-decorated region to which the decorative portion is to be bonded may be used as a part or all of the vehicle or architectural structure. Accordingly, it becomes possible to realize a vehicle or architectural structure including a wall surface or the like that is capable of causing radio waves to be transmitted therethrough while having a metallic appearance, and exhibit an extremely-high design property. Note that the vehicle includes arbitrary vehicles such as an automobile, a bus, and a train. The architectural structure includes arbitrary architectural structures such as a single-family house, complex housing, a facility, and a bridge.

### <Other Embodiments>

The present technology is not limited to the embodiment described above, and various other embodiments can be realized.

As the highly-reflective metal, titanium, chromium, and an alloy containing at least one of them may be used.

Examples of the feature of the metal layer according to the present technology described above include having the first surface having a relatively high hardness and the second surface on the side opposite to the first surface, which has a reflectance higher than that of the first surface and a hardness lower than that of the first surface. Further, examples of the feature of the metal layer according to the present technology include that the hardness decreases from the first surface to the second surface on the side opposite to the first surface, which has a reflectance higher than that of the first surface.

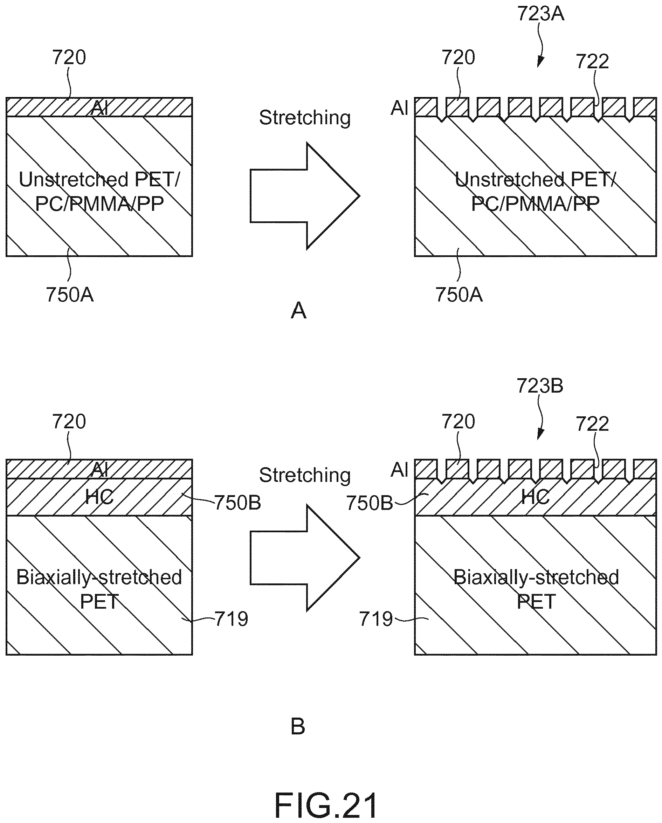

Fig. 21 is a cross-sectional view showing a configuration example of a glossy film according to another embodiment. In this glossy film 723, a support layer 750 having a tensile breakage strength lower than a metal layer 720 is provided as a layer that supports the metal layer 720. Accordingly, it has become possible to lower the stretching rate requisite for forming the minute cracks 722. For example, it is also possible to form the minute cracks 722 with a stretching rate smaller than the stretching rate requisite for breaking the metal layer 720 itself (mainly high hardness layer or the like). This is presumably because the metal layer 720 breaks following a breakage of surfaces of support layers 750A and 750B having a small tensile breakage strength as shown in Parts A and B of Fig. 21.

As shown in Part A of Fig. 21, a base film having a small tensile breakage strength may be used as the support layer 750A. For example, a biaxially-stretched PET has a tensile breakage strength of approximately 200 to approximately 250 MPa, which often becomes higher than the tensile breakage strength of the metal layer 720.

Meanwhile, the tensile breakage strengths of an unstretched PET, PC, PMMA, and PP are as follows.
Unstretched PET: approximately 70 MPa
PC: approximately 69 to approximately 72 MPa
PMMA: approximately 80 MPa
PP: approximately 30 to approximately 72 MPa
Therefore, by using the base film formed of these materials as the support layer 750A, it is possible to appropriately form the minute cracks 522 with a low stretching rate. Note that selecting a non-vinyl chloride material as the support layer 750A is advantageous in preventing metal from being corroded.

As shown in Part B of Fig. 21, a coating layer may be formed on the base film 719 as the support layer 750B. For example, by applying an acrylic resin or the like to form a hard coat layer, the hard coat layer can be easily formed as the support layer 750B.

By forming the coating layer having a small tensile breakage strength between the base film 719 having a large tensile breakage strength and the metal layer 720, formation of the minute cracks 722 at a low stretching rate can be realized while maintaining durability of the glossy film 723B high. Further, this is also effective in the case where the PET needs to be used in terms of the production process, and the like. Note that the breakage of the surfaces of the base film and the hard coat layer that function as the support layers 750A and 750B shown in Parts A and B of Fig. 21 is extremely small, which is approximately a width of the minute cracks 722. Therefore, this does not cause entrainment of air, lowering of a design property, and the like.

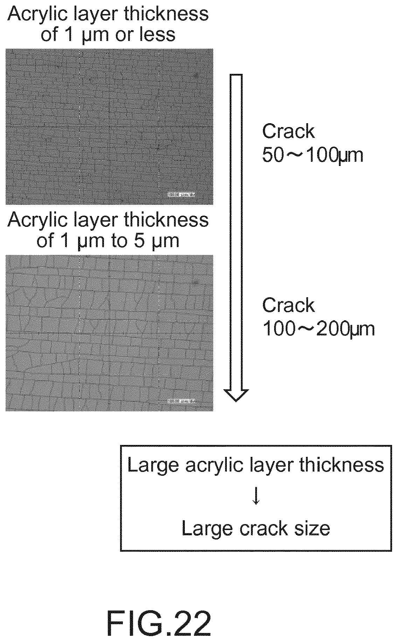

Fig. 22 is a diagram showing a relationship between a thickness of the coating layer formed as the support layer 750B and a pitch (crack interval) of the minute cracks 722 formed in the metal layer 720. Fig. 22 shows the relationship in the case where an acrylic layer is formed as the coating layer.

As shown in Fig. 22, in the case where the thickness of the acrylic layer was 1 µm or less, the pitch of the minute cracks 722 was 50 µm to 100 µm. Meanwhile, in the case where the thickness of the acrylic layer was set within the range of 1 µm to 5 µm, the pitch of the minute cracks 722 was 100 µm to 200 µm. As described above, it was found that the pitch of the minute cracks 722 became larger as the thickness of the acrylic layer became larger. Therefore, the pitch of the minute cracks 722 can be adjusted by controlling the thickness of the acrylic layer as appropriate. For example, by setting the thickness of the acrylic layer within the range of 0.1 µm or more and 10 µm or less, it is possible to adjust the thickness of the minute cracks 722 within a desired range. It goes without saying that the thickness is not limited to this range, and an optimum numerical value range may be set again within the range of 0.1 µm or more and 10 µm or less, for example.

The stretching for forming the minute cracks is not limited to biaxial stretching. Uniaxial stretching or stretching of 3 or more axes may be executed. Further, the biaxial stretching may be further executed by the roll-to-roll method on the base film 19 taken up by the second roll 207 shown in Fig. 6. Furthermore, after the vacuum deposition is further performed, the biaxial stretching may be executed before the take up by the second roll 207.

At least two features of the above-mentioned features according to the present technology may be combined. Specifically, various features described in each embodiment may be arbitrarily combined without distinguishing the embodiments with each other. Further, the various effects described above are merely examples and are not limited, and additional effects may be exerted.

It should be noted that the present technology may take the following configurations.
(1) A structure, including:
   a decorative portion that includes a metal layer having a first surface, a second surface on a side opposite to the first surface, a first internal region, a second internal region, and minute cracks, the second surface having a reflectance higher than that of the first surface, the first internal region having a relatively high hardness on a side of the first surface, the second internal region having a relatively low hardness on a side of the second surface; and
   a member that includes a to-be-decorated region to which the decorative portion is to be bonded.
(2) The structure according to (1), in which
   the metal layer contains a substance and a metal, the substance having a first hardness, the metal having a reflectance higher than that of the substance and a second hardness lower than the first hardness, and
   a proportion of the substance contained in the first internal region is higher than a proportion of the substance contained in the second internal region and a proportion of the metal contained in the second internal region is higher than a proportion of the metal contained in the first internal region.
(3) The structure according to (1) or (2), in which
   the metal layer has a first layer and a second layer, the first layer being formed of a substance having a first hardness, the second layer being formed of a metal having a reflectance higher than that of the substance and a second hardness lower than the first hardness and being stacked on the first layer.
(4) The structure according to (2) or (3), in which
   the substance having the first hardness is a metal, metalloid, metal compound, or metalloid compound.
(5) The structure according to any one of (2) to (4), in which
   the substance having the first hardness is a metal.
(6) The structure according to any one of (2) to (5), in which
   the metal having the second hardness is aluminum, silver, gold, or copper.
(7) The structure according to any one of (2) to (6), in which
   the substance having the first hardness is chromium, silicon, titanium, cobalt, iron, or nickel.
(8) The structure according to any one of (2) to (6), in which
   the substance having the first hardness is aluminum oxide, iron oxide, chromium oxide, cerium oxide, zirconium oxide, titanium oxide, silicon oxide, magnesium oxide, boron nitride, titanium nitride, silicon carbide, or boron carbide.
(9) The structure according to any one of (1) to (8), in which
   the first internal region is a region from a predetermined position between a center in a thickness direction of the metal layer and the first surface to the first surface, and
   the second internal region is a region from a predetermined position between the center and the second surface to the second surface.
(10) The structure according to any one of (1) to (9), in which
   the first internal region has a relatively high Mohs hardness, and
   the second internal region has a relatively low Mohs hardness.
(11) The structure according to any one of (3) to (10), in which
   the first layer has a thickness of 10 nm or more and 300 nm or less, and
   the second layer has a thickness of 30 nm or more and 300 nm or less.
(12) The structure according to any one of (1) to (11), in which
   a pitch of the minute cracks is within a range of 1 µm or more and 500 µm or less.
(13) The structure according to any one of (1) to (12), in which
   the second surface has a surface reflectance of 50% or more in a visible light region.
(1) The structure according to any one of (1) to (13), in which
   the minute cracks are irregularly formed.
(15) The structure according to any one of (1) to (14), in which
   the structure is formed as at least one of a casing component, a vehicle, or an architectural structure.
(16) A decorative film, including:
   a base film; and
   a metal layer that is formed on the base film and has a first surface, a second surface on a side opposite to the first surface, a first internal region, a second internal region, and minute cracks, the second surface having a reflectance higher than that of the first surface, the first internal region having a relatively high hardness on a side of the first surface, the second internal region having a relatively low hardness on a side of the second surface.
(17) A method of producing a structure, including:
   forming a metal layer that has a first surface and a second surface having a reflectance higher than that of the first surface on a base film by deposition such that a hardness of a first internal region on a side of the first surface is higher than that of a second internal region on a side of the second surface;
   forming minute cracks on the metal layer by stretching the base film;
   forming a decorative film including the metal layer on which the minute cracks are formed;
   forming a transfer film by bonding a carrier film onto the decorative film; and
   forming a molded component such that the decorative film is transferred from the transfer film by an in-mold molding method, a hot stamp method, or a vacuum molding method.
(18) A method of producing a structure, including:
   forming a metal layer that has a first surface and a second surface having a reflectance higher than that of the first surface on a base film by deposition such that a hardness of a first internal region on a side of the first surface is higher than that of a second internal region on a side of the second surface;
   forming minute cracks on the metal layer by stretching the base film;
   forming a transfer film including the metal layer on which the minute cracks are formed; and
   forming a molded component such that the metal layer peeled off from the base film is transferred by an in-mold molding method, a hot stamp method, or a vacuum molding method.
(19) A method of producing a structure, including:
   forming a metal layer that has a first surface and a second surface having a reflectance higher than that of the first surface on a base film by deposition such that a hardness of a first internal region on a side of the first surface is higher than that of a second internal region on a side of the second surface;
   forming minute cracks on the metal layer by stretching the base film;
   forming a decorative film including the metal layer on which the minute cracks are formed; and
   forming a molded component integrally with the decorative film by an insert molding method.
(20) A method of producing a decorative film, including:
   forming a metal layer that has a first surface and a second surface having a reflectance higher than that of the first surface on a base film by deposition such that a hardness of a first internal region on a side of the first surface is higher than that of a second internal region on a side of the second surface; and
   forming minute cracks on the metal layer by stretching the base film.
(21) The structure according to any one of (1) to (15), in which
   the metal layer contains a substance and a metal, the substance having a first hardness, the metal having a reflectance higher than that of the substance and a second hardness lower than the first hardness, and a proportion of the substance is lower and a proportion of the metal is higher from the first surface to the second surface.
(22) The structure according to any one of (2) to (15), in which
   the substance having the first hardness is a compound of the metal having the second hardness.
(23) The structure according to any one of (1) to (15), in which
   the hardness of the first internal region is an average hardness of the first internal region, and
   the hardness of the second internal region is an average hardness of the second internal region.
(24) The structure according to any one of (1) to (15), in which
   the second surface has a surface reflectance of 70% or more in a visible light region.
(25) The structure according to any one of (1) to (15), in which
   the decorative film has a protective layer stacked on the second surface, and the protective layer has a surface reflectance of 65% or more in a visible light region.
(26) The structure according to any one of (1) to (15), in which
   the decorative portion includes a support layer that has a tensile breakage strength smaller than that of the metal layer and supports the metal layer.
(27) The structure according to (26), in which
   the support layer portion is a base film.
(28) The structure according to (26), in which
   the substrate portion is a coating layer formed on a base film.
(29) The method of producing a structure according to any one of (17) to (19), in which
   the step of forming the minute cracks includes biaxially stretching the base film with a stretching rate of 2% or less in respective axial directions.
(30) The method of producing a structure according to any one of (17) to (19) and (29), in which
   the step of forming the metal layer includes performing vacuum deposition on the base film conveyed from a feeder roll toward a take-up roll along a circumferential surface of a rotary drum.

### Reference Signs List

- 10: metal decorative portion
- 11, 611: to-be-decorated region
- 12: decorative film
- 19, 619, 719: base film
- 20, 20H to K, 620, 720: metal layer
- 20a: highly-reflective surface
- 20b: high hardness surface
- 22, 522, 622, 722: minute cracks
- 25: high hardness layer
- 26: highly-reflective layer
- 27: first internal region
- 28: second internal region
- 30, 630: transfer film
- 100: mobile terminal
- 101: casing portion
- 200, 300, 400: vacuum deposition apparatus
- 250: biaxial stretching apparatus
- 500, 550: molding apparatus
- 612: decorative portion

## Claims

1. A structure, comprising:
a decorative portion that includes a metal layer having a first surface, a second surface on a side opposite to the first surface, a first internal region, a second internal region, and minute cracks, the second surface having a reflectance higher than that of the first surface, the first internal region having a relatively high hardness on a side of the first surface, the second internal region having a relatively low hardness on a side of the second surface; and
a member that includes a to-be-decorated region to which the decorative portion is to be bonded.

2. The structure according to claim 1, wherein
the metal layer contains a substance and a metal, the substance having a first hardness, the metal having a reflectance higher than that of the substance and a second hardness lower than the first hardness, and
a proportion of the substance contained in the first internal region is higher than a proportion of the substance contained in the second internal region and a proportion of the metal contained in the second internal region is higher than a proportion of the metal contained in the first internal region.

3. The structure according to claim 1, wherein
the metal layer has a first layer and a second layer, the first layer being formed of a substance having a first hardness, the second layer being formed of a metal having a reflectance higher than that of the substance and a second hardness lower than the first hardness and being stacked on the first layer.

4. The structure according to claim 2, wherein
the substance having the first hardness is a metal, metalloid, metal compound, or metalloid compound.

5. The structure according to claim 2, wherein
the substance having the first hardness is a metal.

6. The structure according to claim 2, wherein
the metal having the second hardness is aluminum, silver, gold, or copper.

7. The structure according to claim 2, wherein
the substance having the first hardness is chromium, silicon, titanium, cobalt, iron, or nickel.

8. The structure according to claim 2, wherein
the substance having the first hardness is aluminum oxide, iron oxide, chromium oxide, cerium oxide, zirconium oxide, titanium oxide, silicon oxide, magnesium oxide, boron nitride, titanium nitride, silicon carbide, or boron carbide.

9. The structure according to claim 1, wherein
the first internal region is a region from a predetermined position between a center in a thickness direction of the metal layer and the first surface to the first surface, and
the second internal region is a region from a predetermined position between the center and the second surface to the second surface.

10. The structure according to claim 1, wherein
the first internal region has a relatively high Mohs hardness, and
the second internal region has a relatively low Mohs hardness.

11. The structure according to claim 3, wherein
the first layer has a thickness of 10 nm or more and 300 nm or less, and
the second layer has a thickness of 30 nm or more and 300 nm or less.

12. The structure according to claim 1, wherein
a pitch of the minute cracks is within a range of 1 µm or more and 500 µm or less.

13. The structure according to claim 1, wherein
the second surface has a surface reflectance of 50% or more in a visible light region.

14. The structure according to claim 1, wherein
the minute cracks are irregularly formed.

15. The structure according to claim 1, wherein
the structure is formed as at least one of a casing component, a vehicle, or an architectural structure.

16. A decorative film, comprising:
a base film; and
a metal layer that is formed on the base film and has a first surface, a second surface on a side opposite to the first surface, a first internal region, a second internal region, and minute cracks, the second surface having a reflectance higher than that of the first surface, the first internal region having a relatively high hardness on a side of the first surface, the second internal region having a relatively low hardness on a side of the second surface.

17. A method of producing a structure, comprising:
forming a metal layer that has a first surface and a second surface having a reflectance higher than that of the first surface on a base film by deposition such that a hardness of a first internal region on a side of the first surface is higher than that of a second internal region on a side of the second surface;
forming minute cracks on the metal layer by stretching the base film;
forming a decorative film including the metal layer on which the minute cracks are formed;
forming a transfer film by bonding a carrier film onto the decorative film; and
forming a molded component such that the decorative film is transferred from the transfer film by an in-mold molding method, a hot stamp method, or a vacuum molding method.

18. A method of producing a structure, comprising:
forming a metal layer that has a first surface and a second surface having a reflectance higher than that of the first surface on a base film by deposition such that a hardness of a first internal region on a side of the first surface is higher than that of a second internal region on a side of the second surface;
forming minute cracks on the metal layer by stretching the base film;
forming a transfer film including the metal layer on which the minute cracks are formed; and
forming a molded component such that the metal layer peeled off from the base film is transferred by an in-mold molding method, a hot stamp method, or a vacuum molding method.

19. A method of producing a structure, comprising:
forming a metal layer that has a first surface and a second surface having a reflectance higher than that of the first surface on a base film by deposition such that a hardness of a first internal region on a side of the first surface is higher than that of a second internal region on a side of the second surface;
forming minute cracks on the metal layer by stretching the base film;
forming a decorative film including the metal layer on which the minute cracks are formed; and
forming a molded component integrally with the decorative film by an insert molding method.

20. A method of producing a decorative film, comprising:
forming a metal layer that has a first surface and a second surface having a reflectance higher than that of the first surface on a base film by deposition such that a hardness of a first internal region on a side of the first surface is higher than that of a second internal region on a side of the second surface; and
forming minute cracks on the metal layer by stretching the base film.
